# EUROPEAN PATENT APPLICATION

(11) **EP 4 516 499 A1**
(43) Date of publication of application: **05.03.2025**
(21) Application number: 24195636.6
(22) Date of filing: 21.08.2024
(51) Int. Cl.: B32B 15/20, C08F 6/06, C08F 212/08, C08J 5/24, C08F 257/02, C08F 4/14

(54) **RESIN COMPOSITION AND MANUFACTURING METHOD THEREOF AND SUBSTRATE STRUCTURE**

(30) Priority: 22.08.2023 US 202363578090 P; 29.07.2024 TW 113128082
(71) Applicant: LCY Chemical Corp., Kaohsiung City 812 (TW)
(72) Inventor: Tang, Yi-Hsuan, 812 Kaohsiung City (TW); Chen, Chien-Han, 812 Kaohsiung City (TW); Lee, Wei-Liang, 812 Kaohsiung City (TW); Liao, Ming-Hung, 812 Kaohsiung City (TW); Chen, Yu-Tien, 812 Kaohsiung City (TW); Hsu, Yu-Chen, 812 Kaohsiung City (TW); Shih, Tzu-Yuan, 812 Kaohsiung City (TW); Au-Yeung, Ka Chun, 812 Kaohsiung City (TW)
(74) Representative: Fuchs Patentanwälte Partnerschaft mbB

(57) **Abstract**

A resin composition includes 100 parts by weight of hydrocarbon resin polymers and 0.01 to 50 parts by weight of divinyl aromatic compound. A substrate structure includes a resin layer and a conductive layer disposed on the resin layer, wherein the resin layer is formed from the resin composition. A manufacturing method of the resin composition includes the following steps: providing a mixture, wherein the mixture includes a monovinyl aromatic compound and a divinyl aromatic compound, and optionally includes a bridged ring compound; polymerizing the mixture to form a crude composition; and purifying the crude composition to prepare the resin composition.

## Description

### CROSS REFERENCE TO RELATED APPLICATIONS

This application claims the benefit of U.S. Provisional Application No. 63/578,090, filed on August 22, 2023 and also claims the benefit of Taiwan Application No. 113,128,082 filed on July 29, 2024, the entirety of which is incorporated by reference herein.

### BACKGROUND

### Technical Field

The present disclosure is related to a resin composition, a method for manufacturing the resin composition, and a substrate structure that includes the resin composition. More particularly, it is related to a resin composition that includes a hydrocarbon resin polymer, a method for manufacturing the resin composition, and a substrate structure that includes the resin composition.

### Description of the Related Art

Due to the rise of the cloud, the Internet, and the Internet of Things (IOT), and the improvement of 5G communication technology and display technology, the requirements on materials used to make circuit boards and integrated circuit carriers (IC carriers) required by the optoelectronics, communications and semiconductor industries are becoming increasingly stringent. Copper clad laminate (CCL) is an important material commonly used in electronic products, and is mainly used to manufacture circuit boards. Hydrocarbon resin polymers or polyene materials composed of carbon and hydrogen atoms have the characteristics of low-dielectric loss due to their small number of polar functional groups. Therefore, polymerizable hydrocarbon resin polymers can be used as materials for copper clad laminates or integrated circuit carriers.

Triallyl isocyanurate (TAIC) is often used as a cross-linking agent to cross-link with various resins (such as hydrocarbon resin polymers) to form a resin layer in a copper clad laminate. However, the use of triallyl isocyanurate as a cross-linking agent may result in fuming. In particular, the process of manufacturing copper clad laminate involves a high-temperature process, which may cause thermal decomposition or volatilization (i.e., fuming) of triallyl isocyanurate. In addition, polymerizable hydrocarbon resin polymers are typically purified using organic solvents during preparation. The use of organic solvents is not environmentally friendly and increases costs.

### SUMMARY

In view of the problems above, the present disclosure provides a resin composition, which triallyl isocyanurate is not required to be the cross-linking agent during cross-linking and/or the resin composition can be cross-linked at a lower cross-linking temperature or shorter cross-linking time. The resin composition of the present disclosure does not require the use of organic solvents or the use of organic solvents can be reduced during preparation. The substrate structure prepared using the resin composition of the present disclosure can be obtained in a low-cost, low-energy consumption, and/or environmentally friendly manner. In addition, the substrate structure prepared using the resin composition of the present disclosure can have a good thermal property (for example, high glass transition temperature, Tg) or good electrical performance.

In some embodiments, the present disclosure provides a resin composition. The resin composition includes 100 parts by weight of a hydrocarbon resin polymer; and 0.01 to 50 parts by weight of a divinyl aromatic compound.

In some embodiments, the present disclosure provides a manufacturing method of a resin composition. The method includes the following steps: providing a mixture, wherein the mixture optionally includes a bridged ring compound, a monovinyl aromatic compound, and a divinyl aromatic compound; polymerizing the mixture to form a crude composition; and purifying the crude composition to prepare a resin composition. The resin composition includes 100 parts by weight of a hydrocarbon resin polymer; and 0.01 to 50 parts by weight of a divinyl aromatic compound.

In some embodiments, the present disclosure provides a substrate structure. The substrate structure includes a resin layer, and a conductive layer disposed on the resin layer. The resin layer is formed from a resin composition using a cross-linking process, and the resin composition includes: 100 parts by weight of a hydrocarbon resin polymer; and 0.01 to 50 parts by weight of a divinyl aromatic compound.

### BRIEF DESCRIPTION OF THE DRAWINGS

Embodiments, purposes, features and advantages of the present disclosure can be best understood from the following detailed description in conjunction with the accompanying drawings.
Figure 1 is a flow chart of a manufacturing method of a resin composition, according to some embodiments of the present disclosure.
Figure 2 is a schematic view of a substrate structure, according to some embodiments of the present disclosure.
Figure 3 is a graph illustrating the relationship between storage modulus and loss modulus of the resin composition and temperature, according to some embodiments of the present disclosure.
Figure 4 is a graph illustrating the relationship between storage modulus and loss modulus of the resin composition and time, according to some embodiments of the present disclosure.
Figure 5 is a graph illustrating the relationship between the complex viscosity of the resin composition and time, according to some embodiments of the present disclosure.
Figure 6 is a graph illustrating the relationship between the glass transition temperature of a substrate sample of a resin composition and the DVB content in the resin composition, according to some embodiments of the present disclosure.
Figure 7 is a graph illustrating the relationship between the resin flow of the substrate sample of the resin composition and the DVB content in the resin composition, according to some embodiments of the present disclosure.
Figure 8 is a graph illustrating the relationship between the loss tangent (Df) of the substrate sample of the resin composition and the DVB/TAIC content in the resin composition, according to some embodiments of the present disclosure.

### DETAILED DESCRIPTION

It will be further understood that the terms "comprises," and/or "includes" when used herein, specify the presence of stated features, integers, steps, operations, elements, components and/or groups thereof, but do not preclude the presence or addition of one or more other features, integers, steps, operations, elements, components and/or groups thereof. As used herein, the singular forms "a," "an" and "the" are intended to include the plural forms as well, unless the context clearly indicates otherwise.

It will be understood that, although the terms "first," "second," etc. are be used herein to describe various elements, components, regions, layers and/or portions, these elements, components, regions, layers and/or portions should not be limited by these terms. These terms are used to distinguish one element, component, region, layer or portion from another element, component, region, layer or portion, but not to imply a required sequence of elements.

It will be understood that, the term "about," "approximate," "rough" as used herein usually indicates a value of a given value or range that varies within 20%, preferably within 10%, and preferably within 5%, or within 3%, or within 2%, or within 1%, or within 0.5%. The value given here are approximate value, i.e., "about," "approximate," or "rough" may be implied without specifying "about," "approximate," or "rough." It will be further understood that the values indicated in herein may include the said values as well as deviation values that are within an acceptable deviation range for people having general knowledge in art. It will be understood that the expression "a-b" used herein to indicate a specific range of values is defined as "≧a and ≦b."

Unless otherwise defined, all terms (including technical and scientific terms) used herein have the same meaning as commonly understood by a person skilled in the art to which the invention pertains. It will be further understood that terms, such as those defined in commonly used dictionaries, should be interpreted as having a meaning consistent with the relevant technology and the context or background of this disclosure and will not be interpreted in an idealized or overly formal sense unless expressly so defined herein. Descriptions of known functions and constructions that may unnecessarily obscure the present disclosure will be omitted below.

The term "C₁₋₂₀ alkyl group" used herein refers to a linear, branched, or cyclic aliphatic hydrocarbon monovalent group having 1 to 20 carbon atoms in the main carbon chain. Examples of the C₁₋₂₀ alkyl group include, but are not limited to, a methyl group, an ethyl group, a propyl group, an iso-butyl group, a sec-butyl group, a tert-butyl group, a pentyl group, an iso-amyl group, a hexyl group, a decyl group, a dodecyl group, a cyclohexyl group, a cyclooctyl group, and a cyclododecyl group.

The term "C₂₋₂₀ alkenyl group" used herein refers to a linear, branched, or cyclic aliphatic hydrocarbon monovalent group having 2 to 20 carbon atoms and at least one carbon-carbon double bond in the main carbon chain. Examples of the C₂₋₂₀ alkenyl group include, but are not limited to, an ethenyl group, a propenyl group, an isobutenyl group, a sec-butenyl group, a tert-butenyl group, apentenyl group, an isopentenyl group, a hexenyl group, a decenyl group, a dodecenyl group, a pentadecenyl group, a cyclohexenyl group, a cyclooctenyl group, a cyclopentenyl group, a cyclopentadienyl group, and a cyclopentadecenyl group.

The term "bridged ring compound" used herein refers to a compound including a bridged ring structure. The bridged ring structure refers to a compound that includes at least two carbon rings, and the at least two carbon rings share two carbon atoms that are not directly connected. Examples of the bridged ring compound include, but are not limited to, norbornene (NB, 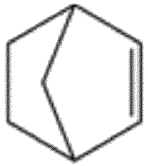 ), dicyclopentadiene (DCPD, 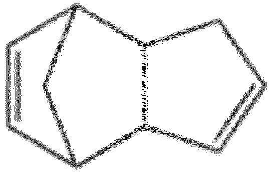 ), norbornadiene (NBD, 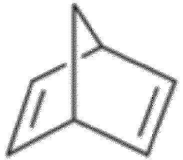 ), 2-acetyl-5-norbornene 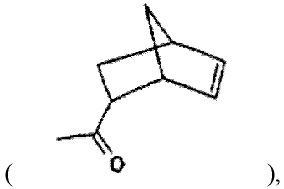 methyl 5-norbornene-2-carboxylate ( 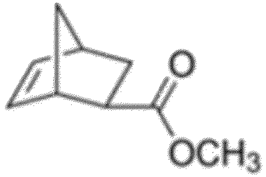 ), vinyl norbornene 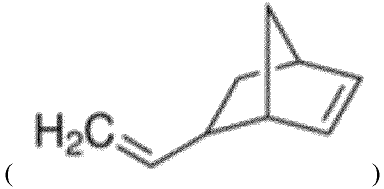 and ethylidene-norbornene

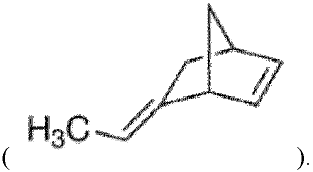

Some embodiments of the present disclosure provide a resin composition. The resin composition includes 100 parts by weight of hydrocarbon resin polymers and 0.01 to 50 parts by weight of divinyl aromatic compound. The hydrocarbon resin polymer in the resin composition of the present disclosure includes cross-linkable groups. In some embodiments, the cross-linkable groups may include unsaturated groups, epoxy groups, or hydroxyl groups, or a combination thereof, but the present disclosure is not limited thereto. In some embodiments, by making the resin composition of the present disclosure include more than 0.01 parts by weight of the divinyl aromatic compound, the resin composition of the present disclosure can be cross-linked without further adding a cross-linking agent. By making the resin composition of the present disclosure include less than 50 parts by weight of the divinyl aromatic compound, the resin composition of the present disclosure can have an appropriate viscosity, thereby having better processability. In some embodiments, based on 100 parts by weight of the hydrocarbon resin polymer, the resin composition of the present disclosure may include 0.1 to 48 parts by weight, 0.2 to 45 parts by weight, or 0.4 to 43 parts by weight of the divinyl aromatic compound.

The storage modulus of the resin composition of the present disclosure exceeds the loss modulus at approximately 125°C to 165°C. That is, the resin composition of the present disclosure has a solid-state property that exceeds a liquid-state property within a temperature of approximately 125°C to 165°C, indicating that the cross-linking temperature of the resin composition is within this temperature range. The detailed measurement method of the cross-linkable temperature will be explained later. The resin composition of the present disclosure has a cross-linkable temperature of about 125°C to 165°C. In some embodiments, the resin composition may have a cross-linkable temperature of about 135°C to 163°C or 135°C to 160°C. In some embodiments, the resin composition can have a cross-linkable temperature of about 140°C to 155°C. A lower cross-linkable temperature means that the resin composition can undergo a cross-linking process at a lower cross-linking temperature, thereby reducing the energy required during the cross-linking process.

The resin composition of the present disclosure may have a storage modulus of about 10,000 to 10,000,000 Pa after a cross-linking time of 2,000 seconds at a cross-linking temperature of 160°C. In some embodiments, the resin composition has a storage modulus of about 20,000 to 9,000,000 Pa or 21,000 to 8,500,000 Pa after a cross-linking time of 2,000 seconds at a cross-linking temperature of 160°C. In some embodiments, the resin composition has a storage modulus of about 100,000 to 2,000,000 Pa or 200,000 to 1,000,000 Pa after a cross-linking time of 2,000 seconds at a cross-linking temperature of 160°C.

The cross-linking time corresponding to the storage modulus obtained by multiplying the storage modulus obtained by subjecting the resin composition to a cross-linking temperature of 160°C and a cross-linking time of 2,000 seconds by 0.9 times is defined as the "required cross-linking time." In some embodiments, the "required cross-linking time" of the resin composition of the present disclosure is about 1300 to 1900 seconds, which indicates that the resin composition of the present disclosure can be substantially cross-linked after a cross-linking time of about 1300 to 1900 seconds. In some embodiments, the "required cross-linking time" of the resin composition of the present disclosure is about 1700 to 1850 seconds.

The resin composition of the present disclosure may have a complex viscosity of about 1.00 × 10⁴ to 6.00 × 10⁸ cP after half of the "required cross-linking time" at a cross-linking temperature of 160°C, for example, 1.00 × 10⁶ to 1.00 × 10⁸ cP, 1.00 × 10⁷ to 1.00 × 10⁸ cP, 1.00 × 10⁷ to 5.00 × 10⁷ cP.

In some embodiments, the hydrocarbon resin polymer in the resin composition of the present disclosure may include a repeating unit (B) derived from a monovinyl aromatic compound and a repeating unit (C) derived from a divinyl aromatic compound.

Herein, the monovinyl aromatic compound refers to a compound that includes a carbocyclic aromatic structure, and one hydrogen on the ring carbon atom of the carbocyclic aromatic structure is replaced by a vinyl group. In some embodiments, the vinyl group may be unsubstituted. In some embodiments, at least one hydrogen atom on the vinyl group may be replaced by a C₁₋₂₀ alkyl group. In some embodiments, the carbocyclic aromatic structure may include 6 to 60 or 6 to 20 ring carbon atoms. In some embodiments, the carbocyclic aromatic structure may be unsubstituted. In some embodiments, at least one hydrogen on the ring carbon atom in the carbocyclic aromatic structure may be replaced by a C₁₋₂₀ alkyl group. The monovinyl aromatic compound may include, for example, styrene, methyl styrene, or ethyl styrene, but the present disclosure is not limited thereto.

The repeating unit (B) derived from the monovinyl aromatic compound includes a carbocyclic aromatic structure derived from the monovinyl aromatic compound. For example, in some embodiments, the repeating unit (B) may have the following structure, but the present disclosure is not limited thereto: 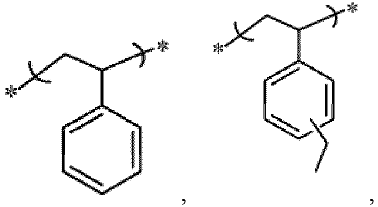 or 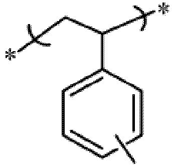 . The "*" in the structure above indicates the position where it is connected to other groups or units.

Herein, the divinyl aromatic compound refers to a compound that includes a carbocyclic aromatic structure, and two hydrogens on the ring carbon atom of the carbocyclic aromatic structure are replaced by vinyl groups. In some embodiments, the vinyl groups may be unsubstituted. In some embodiments, at least one hydrogen atom on the vinyl groups may be replaced by a C₁₋₂₀ alkyl group. In some embodiments, the carbocyclic aromatic structure may include 6 to 60 or 6 to 20 ring carbon atoms. In some embodiments, the carbocyclic aromatic structure may be unsubstituted. In some embodiments, at least one hydrogen on the ring carbon atom of the carbocyclic aromatic structure may be replaced by a C₁₋₂₀ alkyl group. The divinyl aromatic compound may include, for example, divinylbenzene or diisopropenylbenzene, but the present disclosure is not limited thereto.

The repeating unit (C) derived from the divinyl aromatic compound includes a carbocyclic aromatic structure derived from the divinyl aromatic compound. In some embodiments, the repeating unit (C) may include a cross-linkable repeating unit (C1) and a cross-linked repeating unit (C2): 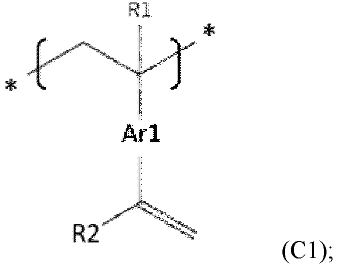 and

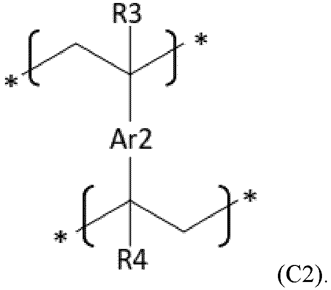

R1, R2, R3, and R4 in the cross-linkable repeating unit (C1) and the cross-linked repeating unit (C2) may each be independently H or a C₁₋₂₀ alkyl group, and Ar1 and Ar2 may be a phenylene group. The "*" indicates the connecting position between the cross-linkable repeating unit (C1) and/or the cross-linked repeating unit (C2) and other groups or units. In some embodiments, the cross-linkable repeating unit (C1) may include a structure as shown below, but the present disclosure is not limited thereto: 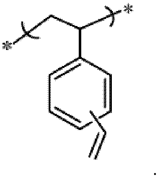 In some embodiments, the cross-linked repeating unit (C2) may include a structure as shown below, but the present disclosure is not limited thereto:

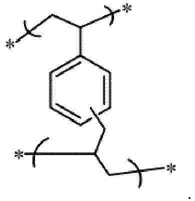

In some embodiments, based on 100 mol% of the hydrocarbon resin polymer, the hydrocarbon resin polymer may include 15 to 95 mol% of the repeating unit (B) and 5 to 85 mol% of the repeating unit (C). When the content of the repeating unit (B) and the repeating unit (C) in the hydrocarbon resin polymer is within the range above, the hydrocarbon resin polymer may have better thermal properties and/or processability. In some embodiments, based on 100 mol% of the hydrocarbon resin polymer, the hydrocarbon resin polymer may include 35 to 94 mol% of the repeating unit (B) and 6 to 55 mol% of the repeating unit (C), 45 to 93 mol% of the repeating unit (B) and 7 to 45 mol% of the repeating unit (C), or 55 to 92 mol% of the repeating unit (B) and 8 to 35 mol% of the repeating unit (C). In some embodiments, based on 100 mol% of the hydrocarbon resin polymer, the hydrocarbon resin polymer may include 1 to 30 mol% of the cross-linkable repeating unit (C1). When the content of the cross-linkable repeating unit (C1) in the hydrocarbon resin polymer is within the range above, the hydrocarbon resin polymer may have better thermal property, electrical performance, and/or processability.

In some embodiments, the hydrocarbon resin polymer in the resin composition of the present disclosure may further include a repeating unit (A) derived from a bridged ring compound. In some embodiments, the bridged ring compound may include 3 to 12 ring-forming atoms and 1 to 2 double bonds. In some embodiments, the bridged ring compound may be unsubstituted. In some embodiments, at least one hydrogen atom on the bridged ring compound may be substituted with at least one substituent selected from the group consisting of a C₁₋₂₀ alkyl group, C₂₋₂₀ alkenyl group, or a carboxylate group with a main carbon chain of 1 to 20 carbon atoms. In some embodiments, the bridged ring compound includes at least two substituents. The at least two substituents may be any two substituents selected from the group consisting of a C₁₋₂₀ alkyl group, C₂₋₂₀ alkenyl group, or a carboxylate group with a main carbon chain of 1 to 20 carbon atoms. Adjacent substituents of the at least two substituents may form a ring. Examples of the bridged ring compound may include dicyclopentadiene or norbornene, but the present disclosure is not limited thereto.

In some embodiments, the repeating unit (A) may have the following structures, but the present disclosure is not limited thereto:

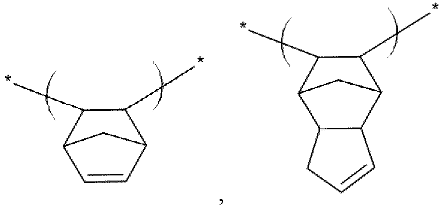

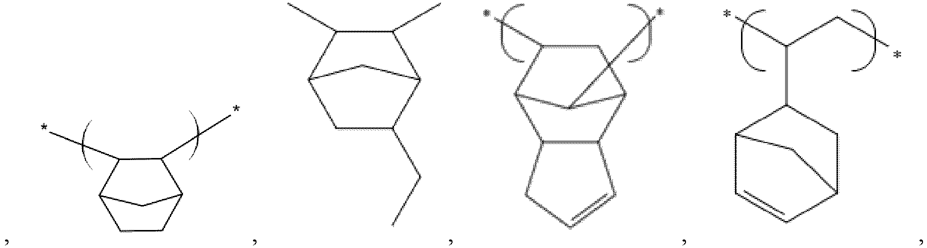

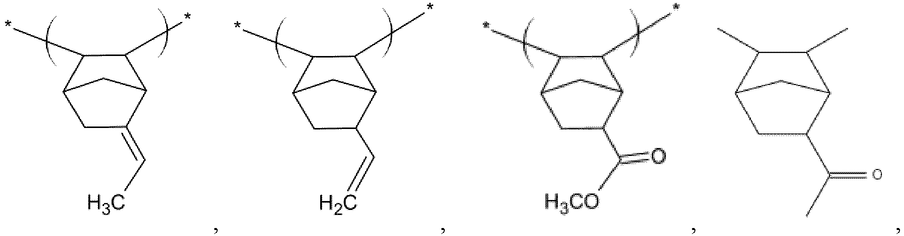

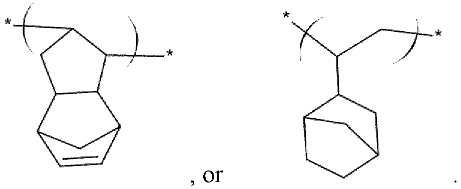

The "*" in the structures above indicates the position where it is connected to other groups or units. Compared with a linear repeating unit, the repeating unit (A) derived from the bridged ring compound have higher rigidity. Therefore, the glass transition temperature of the hydrocarbon resin polymer can be increased or the thermal property of the hydrocarbon resin polymer can be improved.

In some embodiments, based on 100 mol% of the hydrocarbon resin polymer, the hydrocarbon resin polymer may include 0.15 to 15 mol% of the repeating unit (A). When the content of the repeating unit (A) in the hydrocarbon resin polymer is within the range above, the hydrocarbon resin polymer can have better thermal property and lower manufacturing cost. In some embodiments, based on 100 mol% of the hydrocarbon resin polymer, the hydrocarbon resin polymer may include 0.5 to 12 mol%, 1 to 10 mol%, or 1.5 to 8 mol% of the repeating unit (A).

In some embodiments, based on 100 mol% of the hydrocarbon resin polymer, the total content of the repeating unit (A) and the repeating unit (C) of the hydrocarbon resin polymer is greater than or equal to 13 mol%. The repeating unit (A) and repeating unit (C) will affect the thermal property and thermal stability of the hydrocarbon resin polymer. The total content of the repeating unit (A) and the repeating unit (C) of the hydrocarbon resin polymer is greater than or equal to 13 mol%, which can provide excellent thermal property and thermal stability of the hydrocarbon resin polymer. In some embodiments, based on 100 mol% of the hydrocarbon resin polymer, the total content of the repeating unit (A) and the repeating unit (C) of the hydrocarbon resin polymer may be greater than or equal to 15 mol%, 17 mol%, or 20 mol%. In some embodiments, based on 100 mol% of the hydrocarbon resin polymer, the total content of the repeating unit (A) and the repeating unit (C) of the hydrocarbon resin polymer may be less than or equal to 45 mol%, 40 mol%, or 35 mol%.

In some embodiments, the hydrocarbon resin polymer may include a reactive double bond. The "reactive double bond" in the present disclosure refers to a double bond in the repeating unit (A) or repeating unit (C) that can react with other compounds or polymers. For example, in some embodiments, the reactive double bond includes the double bond in the repeating unit (A) shown below: 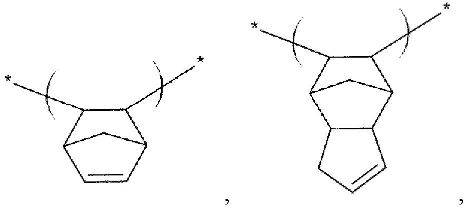 or 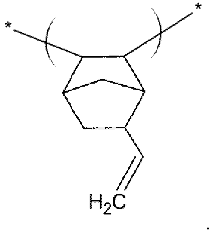 For example, in some embodiments, the reactive double bond includes the double bond on the non-benzene ring in the repeating unit (C) shown below: 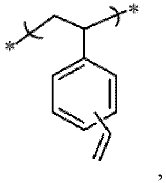 but the present disclosure is not limited thereto.

In some embodiments, the hydrogen content of the reactive double bond of the hydrocarbon resin polymer may be less than 10%. If the hydrogen content of the reactive double bond in the hydrocarbon resin polymer is too high, for example, higher than 10%, the hydrocarbon resin polymer will be easily oxidized during a heating process, resulting in poor electrical performance of the hydrocarbon resin polymer. In some embodiments, the hydrogen content of the reactive double bond in the hydrocarbon resin polymer may be greater than 0.2%. If the hydrogen content of the reactive double bond in the hydrocarbon resin polymer is too low, for example, less than 0.2%, a peel strength of a layer including the hydrocarbon resin polymer may be too low. In some embodiments, the hydrogen content of the reactive double bond in the hydrocarbon resin polymer may be 0.2% to 10%, 0.3% to 9%, 0.4% to 8%, or 0.5% to 7%. When the hydrogen content of the reactive double bond in the hydrocarbon resin polymer is within the range above, the hydrocarbon resin polymer is not easily oxidized in a high temperature environment (for example, above 150°C) or tends to complete the cross-linking reaction before oxidation. Therefore, the electrical performance of the hydrocarbon resin polymer can be improved. In some embodiments, the number average molecular weight (Mn) of the hydrocarbon resin polymer may range from 2,500 to 15,000 g/mol. If the number average molecular weight of the hydrocarbon resin polymer is too high, the solubility of the hydrocarbon resin polymer will decrease. In some embodiments, the number average molecular weight of the hydrocarbon resin polymer may be 2,500 to 13,000 g/mol, 2,800 to 12,000 g/mol, or 3,000 to 11,000 g/mol.

In some embodiments, the hydrocarbon resin polymer may have a polymer dispersity index (PDI) of less than 20. When the polymer dispersion index of the hydrocarbon resin polymer is less than 20, the hydrocarbon resin polymer will have better processability. In some embodiments, the hydrocarbon resin polymer may have a polymer dispersion index greater than 1.5. In some embodiments, the polymer dispersion index of the hydrocarbon resin polymer may be 1.5 to 20, 2 to 18, or 2.2 to 16.5.

In some embodiments, the resin composition may further include 5 to 350 parts by weight of solvent. The resin composition having the above content of the solvent may have good processability. In some embodiments, based on 100 parts by weight of the hydrocarbon resin polymer, the resin composition of the present disclosure may include 6 to 340 parts by weight, 10 to 340 parts by weight, or 30 to 340 parts by weight of the solvent. The solvent can be any possible organic solvent. In some embodiments, the solvent may be toluene.

In some embodiments, the resin composition may further include a monovinyl aromatic compound. In some embodiments, based on 100 parts by weight of the hydrocarbon resin polymer, the resin composition of the present disclosure may include 0.1 to 50 parts by weight, 0.1 to 40 parts by weight, or 0.1 to 30 parts by weight of the monovinyl aromatic compound. In some embodiments, the monovinyl aromatic compound may include styrene and/or ethyl styrene, but the present disclosure is not limited thereto.

The resin composition of the present disclosure having the above components and contents can have at least one of the advantages of low composition viscosity, low resin flow, low cross-linking temperature, short cross-linking time, high glass transition temperature, good electrical performance, and no fuming during a cross-linking process.

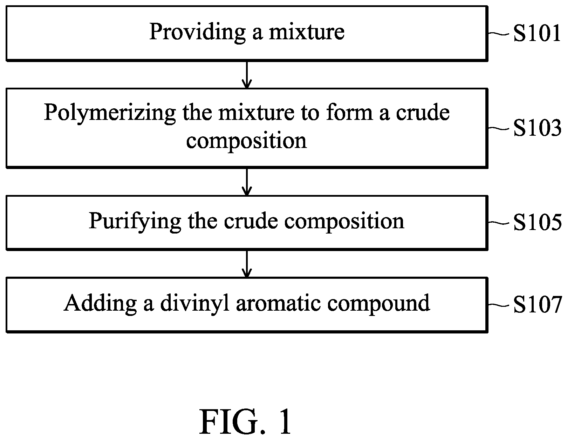

Some embodiments of the present disclosure provide a manufacturing method of a resin composition. Figure 1 is the flow chart of the manufacturing method of the resin composition, according to some embodiments of the present disclosure. Referring to Figure 1, the manufacturing method of the resin composition of the present disclosure includes a step S101 of providing a mixture; a step S103 of polymerizing the mixture to form a crude composition; a step S105 of purifying the crude composition; and a step S107 of adding a divinyl aromatic compound.

The mixture provided in step S101 includes an optional bridged ring compound, a monovinyl aromatic compound, and a divinyl aromatic compound. In some embodiments, the mixture provided in step S101 includes, based on 100 mol% of the mixture, 0 to 50 mol% of the bridged ring compound, 60 to 95 mol% of the monovinyl aromatic compound, and 0.5 to 15 mol% of the divinyl aromatic compound. In some embodiments, the mixture provided in step S101 includes, based on 100 mol% of the mixture, 0 to 30 mol% of the bridged ring compound, 65 to 95 mol% of the monovinyl aromatic compound, and 0.5 to 12 mol% of the divinyl aromatic compound. In some embodiments, the mixture provided in step S101 includes, based on 100 mol% of the mixture, 0 to 25 mol% of the bridged ring compound, 70 to 95 mol% of the monovinyl aromatic compound, and 0.5 to 10 mol% of the divinyl aromatic compound. The definitions and examples of the bridged ring compound, the monovinyl aromatic compound, and the divinyl aromatic compound are mentioned above, and will not be repeated herein.

In some embodiments, the step S103 may include polymerizing the mixture provided in the step S101 at a polymerization temperature of 0°C to 80°C. In some embodiments, the polymerization temperature may be 0 to 45°C, 0 to 40°C, 0 to 35°C, or 0 to 30°C. In some embodiments, the step S103 may include polymerizing the mixture provided in the step S101 using a catalyst. In some embodiments, the catalyst may include boron trifluoride-diethyl ether complex (BF₃-OEt₂), titanium tetrachloride (TiCl₄), or a combination thereof, but the present disclosure is not limited thereto.

The crude composition obtained in the step S103 is purified in the step S105. In some embodiments, the step S 105 may include extracting the crude composition obtained in the step S103 with isopropyl alcohol (IPA), but the present disclosure is not limited thereto. In some embodiments, the step S 105 may include extracting the crude composition obtained in the step S 103 with water. The step S 107 of adding the divinyl aromatic compound may be performed optionally after the step S105. In particular, if the content of the divinyl aromatic compound in the crude composition purified in step S105 is less than 0.01 parts by weight based on 100 parts by weight of the hydrocarbon resin polymer, or is desired to adjust the content of the divinyl aromatic compound in the crude composition, the step S107 will be further performed. Otherwise, the step S107 may be omitted. For example, in some embodiments, where the step S 105 includes extracting the crude composition with water, the step S107 may be omitted. In an embodiment in which the step S105 includes extracting the crude composition with isopropyl alcohol, the step S107 may be performed after the step S105, but the present disclosure is not limited thereto. The resin composition of the present disclosure can be obtained after the step S 105 or the step S107.

The resin composition obtained according to the manufacturing method of the resin composition of the present disclosure is described above, and will not be repeated herein. The manufacturing method of the present disclosure can obtain the resin composition in a low-cost, low-energy, and/or environmentally friendly manner. The resin composition can have at least one of the advantages of appropriate composition viscosity, low resin flow, low cross-linking temperature, short cross-linking time, high glass transition temperature, good electrical performance, and no fuming during a cross-linking process.

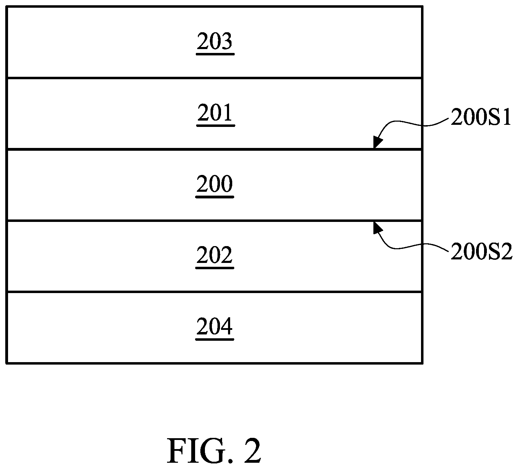

In some embodiments, the present disclosure provides a substrate structure. Figure 2 is a schematic view of the substrate structure, according to some embodiments of the present disclosure. Referring to Figure 2, the substrate structure of the present disclosure includes a base layer 200, a conductive layer 203 disposed on the base layer 200, and a resin layer 201 disposed between the conductive layer 203 and the base layer 200. The resin layer 201 is formed of the resin composition through the cross-linking process mentioned above.

In some embodiments, the base layer 200 may include polyimide (PI), polycarbonate (PC), polyethylene terephthalate (PET), glass, quartz, sapphire, ceramic, plastic, agaric Ajinomoto build-up Film (ABF), fiberglass paper, cotton paper, or a combination thereof, but the present disclosure is not limited thereto.

In some embodiments, the conductive layer 203 may include copper (Cu), aluminum (Al), molybdenum (Mo), tungsten (W), gold (Au), chromium (Cr), nickel (Ni), platinum (Pt), titanium (Ti), another suitable metal material, or a combination thereof, but the present disclosure is not limited thereto. In some embodiments, the conductive layer 203 may have a single-layer structure or a multi-layer stacked structure. For example, conductive layer 203 may include a single layer of metallic copper.

The base layer 200 may have a first surface 200S1 and a second surface 200S2 opposite to the first surface 200S1. The conductive layer 203 may be disposed on the first surface 20051 of the base layer 200, and the resin layer 201 may be disposed between the first surface 20051 of the base layer 200 and the conductive layer 203.

In some embodiments, the substrate structure may further include another conductive layer 204 on the second surface 200S2 of the base layer 200 and another resin layer 202 disposed between the second surface 200S2 of the base layer 200 and the conductive layer 204. The other resin layer 202 may include the same material as the resin layer 201. The other conductive layer 204 may include copper (Cu), aluminum (Al), molybdenum (Mo), tungsten (W), gold (Au), chromium (Cr), nickel (Ni), platinum (Pt), titanium (Ti ), another suitable metal material, or a combination thereof, but the present disclosure is not limited thereto. In some embodiments, the other conductive layer 204 may have a single-layer structure or a multi-layer stacked structure. The other conductive layer 204 may include the same or different material and the same or different structure as the conductive layer 203 . For example, the other conductive layer 204 may include a single layer of metallic copper.

The substrate structure with the above structure can be obtained in a low-cost, low-energy consumption, and/or environmentally friendly manner. In addition, the substrate structure having the above structure can have at least one of the advantages of good thermal performance (for example, high glass transition temperature (Tg)) and good electrical performance.

One or more embodiments of the present disclosure will be described in detail with the following examples. However, these examples are used to illustrate the embodiments of the present disclosure and are not intended to limit the scope of the embodiments of the present disclosure.

### Preparation of Polymers 1 to 15

### Polymer 1

### Reaction Process

203.1 g (20 mol%) of dicyclopentadiene (DCPD), 536 g (67 mol%) of styrene, 130 g (13 mol%) of divinylbenzene (DVB (The purity is 63%, and the remaining 37% is ethyl styrene), and 1113.6 g of toluene were added to a 3-liter four-neck vertical jacketed reactor under nitrogen, and stirred using a double-layer four-wing flat blade with a stirring speed set to 400 rpm to form a mixture. A syringe pump was used to inject 21.8 g of boron trifluoride-diethyl ether complex (BF₃-OEt₂) catalyst at a rate of 1.0 mL/min at low temperature (0°C). After adding the catalyst, the reaction temperature was raised to 10°C and maintained for 10 minutes, then to 15°C and maintained for 3 hours. 65.4 g of isopropyl alcohol was added to terminate the polymerization reaction to obtain a polymer stock solution, and it was confirmed that the viscosity of the polymer stock solution at the time of termination was 4.7 cp.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid, which was then repeatedly redissolved in toluene (The weight ratio of the stock solution to isopropyl alcohol is 1:5.). After filtration, a purer white resin solid was obtained. The white resin solid was washed with methanol to remove impurities and isopropyl alcohol, and heated and stirred under vacuum to remove the solvent to obtain a white powder of hydrocarbon resin polymer as Polymer 1.

### Polymer 2

### Reaction Process

0.6498 kg (20 mol%) of dicyclopentadiene, 1.715 kg (67 mol%) of styrene, 0.416 kg (13 mol%) of divinylbenzene (The purity is 63%, and the remaining 37% is ethyl styrene), and 3.5635 kg of toluene were added to a 10-liter four-neck vertical jacketed reactor under nitrogen, and stirred using a triple-layer six-wing flat blade with a stirring speed set to 200 rpm to form a mixture. A syringe pump was used to inject 0.06976 kg of boron trifluoride-diethyl ether complex catalyst at a rate of 0.25 mL/min at low temperature (0°C). After adding the catalyst, the reaction temperature was raised to 10°C and maintained for 10 minutes, then to 20°C and maintained for 2 hours. 0.2092 kg of isopropyl alcohol was added to terminate the polymerization reaction to obtain a polymer stock solution, and it was confirmed that the viscosity of the polymer stock solution at the time of termination was 11.67 cp.

### Purification Process

A bag filter was used to filter impurities and insoluble matter in the polymer stock solution. A pneumatic pump was used to inject isopropyl alcohol into another large mixing tank equipped with a mechanical stirrer rotating at 300 rpm. The weight of isopropyl alcohol is 5 times the weight of polymer stock solution. A hose pump (with rotation speed set to 100 rpm) was used to slowly inject the polymer stock solution to precipitate a white crude resin product in the tank. The solid-liquid phase was filtered through a large filter press to obtain a white solid, which was then repeatedly redissolved in toluene (The weight ratio of the polymer stock solution to isopropyl alcohol is 1:5.). After filtration, a purer white resin solid was obtained. The white resin solid was washed with methanol to remove impurities and isopropyl alcohol, and heated and stirred under vacuum to remove the solvent to obtain a white powder of hydrocarbon resin polymer as Polymer 2.

### Polymer 3

### Reaction Process

21.6 g (17 mol%) of dicyclopentadiene (with purity of 95%), 70 g (70 mol%) of styrene (with purity of 99.8%), 16.25 g (13 mol%) of divinylbenzene (The purity is 63%, and the remaining 37% is ethyl styrene), and 160 mL of toluene were added to a 1-liter four-neck vertical jacketed reactor under nitrogen, and stirred using a single-layer four-wing flat blade with a stirring speed set to 400 rpm to form a mixture. A syringe pump was used to inject 2.73 g of boron trifluoride-diethyl ether complex catalyst at a rate of 0.25 mL/min at low temperature (10°C). After adding the catalyst, the reaction was carried out for two hours. 8.1 g of isopropyl alcohol was added to terminate the polymerization reaction to obtain a polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid, which was then repeatedly redissolved in toluene (The weight ratio of the polymer stock solution to isopropyl alcohol is 1:5.). After filtration, a purer white resin solid was obtained. The white resin solid was washed with methanol to remove impurities and isopropyl alcohol, and heated and stirred under vacuum to remove the solvent to obtain a white powder of hydrocarbon resin polymer as Polymer 3.

### Polymer 4

### Reaction Process

69.70 g (87 mol%) of styrene, 13.02 g (13 mol%) of divinylbenzene (The purity is 63%, and the remaining 37% is ethyl styrene), and 222.31 g of toluene were added to a 1-liter four-neck vertical jacketed reactor under nitrogen, and stirred using a four-wing flat blade with a stirring speed set to 400 rpm to form a mixture. A syringe pump was used to inject 1.1 g of boron trifluoride-diethyl ether complex catalyst at a rate of 0.25 mL/min at a reaction temperature of 20 °C. After one and a half hours, 69 g of water was added to terminate the polymerization reaction to obtain a polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid. The white solid was washed with methanol to remove impurities and isopropyl alcohol, and heated at 60 °C under nitrogen to remove the solvent to obtain a white powder of hydrocarbon resin polymer as Polymer 4. The yield was about 50%.

### Polymer 5

### Reaction Process

34.88 g (87 mol%) of styrene, 6.51 g (13 mol%) of divinylbenzene (The purity is 63%, and the remaining 37% is ethyl styrene), and 222.63 g of toluene were added to a 1-liter four-neck vertical jacketed reactor under nitrogen, and stirred using a four-wing flat blade with a stirring speed set to 400 rpm to form a mixture. A syringe pump was used to inject 1.1 g of boron trifluoride-diethyl ether complex catalyst at a rate of 0.25 mL/min at a reaction temperature of 20 °C. After four hours, 3.96 g of isopropyl alcohol was added to terminate the polymerization reaction to obtain a polymer stock solution.

### Purification Process

First, the polymer stock solution was diluted with 94 g of toluene. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid. The white solid was washed with methanol to remove impurities and isopropyl alcohol, and heated at 60 °C under nitrogen to remove the solvent to obtain a white powder of hydrocarbon resin polymer as Polymer 5. The yield was about 50%.

### Polymer 6

### Reaction Process

3.59 g (5.7 mol%) of divinylbenzene (The purity is 63%, and the remaining 37% is ethyl styrene), and 19.2 g (87 mol%) of styrene were added to a 250 mL round-bottomed flask under nitrogen. 20 g of xylene mixture was added to the above mixture at 25 °C. 0.1 mL of 1M TiCl₄ solution and 0.006 g of NaBArF₄ were added to initiate the polymerization reaction. The color of the mixture changed from colorless to red after 30 minutes. 1 mL of isopropyl alcohol was added to terminate the polymerization reaction to obtain a polymer solution.

### Purification Process

The polymer solution was precipitated from isopropyl alcohol (IPA, 500 mL) to obtain orange powder. The obtained orange powder was dried at 60 °C for 3 hours to obtain Polymer 6. The yield was 18.6 g (81%).

### Polymer 7

### Reaction Process

21.58 g (17 mol%) of dicyclopentadiene (with purity of 95%), 52.99 g (53 mol%) of styrene (with purity of 99.8%), 37.50 g (30 mol%) of divinylbenzene (The purity is 63%, and the remaining 37% is ethyl styrene), and 160 mL of toluene were added to a 1-liter four-neck vertical jacketed reactor under nitrogen, and stirred using a single-layer four-wing flat blade with a stirring speed set to 400 rpm to form a mixture. A syringe pump was used to inject 1.36 g of boron trifluoride-diethyl ether complex catalyst at a rate of 0.25 mL/min at low temperature (0°C). After adding the catalyst, the reaction was carried out for two hours. 4.1 g of isopropyl alcohol was added to terminate the polymerization reaction to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid, which was then repeatedly redissolved in toluene (The weight ratio of the polymer stock solution to isopropyl alcohol is 1:5.). After filtration, a purer white resin solid was obtained. The white resin solid was heated and stirred under vacuum to remove the solvent to obtain 30.5 g of a white powder of hydrocarbon resin polymer as Polymer 7.

### Polymer 8

### Reaction Process

21.58 g (17 mol%) of dicyclopentadiene (with purity of 95%), 56.99 g (57 mol%) of styrene (with purity of 99.8%), 32.50 g (26 mol%) of divinylbenzene (The purity is 63%, and the remaining 37% is ethyl styrene), and 160 mL of toluene were added to a 1-liter four-neck vertical jacketed reactor under nitrogen, and stirred using a single-layer four-wing flat blade with a stirring speed set to 400 rpm to form a mixture. A syringe pump was used to inject 1.36 g of boron trifluoride-diethyl ether complex catalyst at a rate of 0.25 mL/min at low temperature (0°C). After adding the catalyst, the reaction was carried out for two hours. 4.1 g of isopropyl alcohol was added to terminate the polymerization reaction to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid, which was then repeatedly redissolved in toluene (The weight ratio of the polymer stock solution to isopropyl alcohol is 1:5.). After filtration, a purer white resin solid was obtained. The white resin solid was washed with methanol to remove impurities and isopropyl alcohol, and heated and stirred under vacuum to remove the solvent to obtain 35.7 g of a white powder of hydrocarbon resin polymer as Polymer 8.

### Polymer 9

### Reaction Process

21.6 g (17 mol%) of dicyclopentadiene (with purity of 95%), 59.99 g (60 mol%) of styrene (with purity of 99.8%), 28.75 g (23 mol%) of divinylbenzene (The purity is 63%, and the remaining 37% is ethyl styrene), and 160 mL of toluene were added to a 1-liter four-neck vertical jacketed reactor under nitrogen, and stirred using a single-layer four-wing flat blade with a stirring speed set to 400 rpm to form a mixture. A syringe pump was used to inject 2.73 g of boron trifluoride-diethyl ether complex catalyst at a rate of 0.25 mL/min at low temperature (0°C). After adding the catalyst, the reaction was carried out for two hours. 8.1 g of isopropyl alcohol was added to terminate the polymerization reaction to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid, which was then repeatedly redissolved in toluene (The weight ratio of the polymer stock solution to isopropyl alcohol is 1:5.). After filtration, a purer white resin solid was obtained. The white resin solid was washed with methanol to remove impurities and isopropyl alcohol, and heated and stirred under vacuum to remove the solvent to obtain 40.1 g of a white powder of hydrocarbon resin polymer as Polymer 9.

### Polymer 10

### Reaction Process

24.9 g (30 mol%) of divinylbenzene (The purity is 63%, and the remaining 37% is ethyl styrene), and 46.5 g (70 mol%) of styrene were added to a 250 mL round-bottomed flask under nitrogen. 60 g of toluene was added to the above mixture at 40°C. 2.6 g of 1M TiCl₄ solution was added to initiate the polymerization reaction. The color of the mixture changed from colorless to red/brown after 3 hours. 1 mL of isopropyl alcohol was added to terminate the polymerization reaction to obtain a polymer solution.

### Purification Process

The red polymer solution was precipitated from isopropyl alcohol (IPA, 500 mL) to obtain orange powder. The obtained orange powder was dried at 60°C for 3 hours to obtain Polymer 10. The yield was 37.8 g (53%).

### Polymer 11

### Reaction Process

12.7 g (40 mol%) of divinylbenzene (The purity is 63%, and the remaining 37% is ethyl styrene), and 15.3 g (60 mol%) of styrene were added to a 250 mL round-bottomed flask under nitrogen. 50 g of toluene was added to the above mixture at 75°C. 0.15 g of BF₃-OEt₂ solution was added to initiate the polymerization reaction. The color of the mixture changed from colorless to yellow after 1.5 hours. 1 mL of isopropyl alcohol was added to terminate the polymerization reaction to obtain a polymer solution.

### Purification Process

The red polymer solution was precipitated from isopropyl alcohol (IPA, 500 mL) to obtain orange powder. The obtained orange powder was dried at 60°C for 3 hours to obtain Polymer 11. The yield was 16.0 g (57%).

### Polymer 12

### Reaction Process

37.49 g (60 mol%) of styrene, 15.63 g (20 mol%) of divinylbenzene (The purity is 63%, and the remaining 37% is ethyl styrene), 15.864 g of (20 mol%) of dicyclopentadiene (DCPD), and 173.4 g of toluene were added to a 1-liter four-neck vertical jacketed reactor under nitrogen, and stirred using a four-wing flat blade with a stirring speed set to 400 rpm to form a mixture. A syringe pump was used to inject 1.7 g of boron trifluoride-diethyl ether complex catalyst at a rate of 0.25 mL/min at a reaction temperature of 20°C. After 3 hours, 5.37 g of isopropyl alcohol was added to terminate the polymerization reaction to obtain a polymer stock solution.

### Purification Process

First, the polymer stock solution was diluted with 62 g of toluene. The polymer stock solution was stirred using a mechanical stirrer with a rotation speed of 500 rpm. The polymer stock solution was slowly dropped into isopropyl alcohol through an addition funnel to obtain a white crude resin product. The weight of isopropyl alcohol is 5 times the weight of polymer stock solution. The solid-liquid phase was filtered by suction to obtain a white solid. The white solid was washed with methanol to remove impurities and isopropyl alcohol, and heated at 60°C under nitrogen to remove the solvent to obtain a white powder of hydrocarbon resin polymer as Polymer 12. The yield was about 38%.

### Varnish Solution Containing Polymer 13

### Reaction Process

20 mol% of dicyclopentadiene (DCPD), 13 mol% of divinylbenzene (The purity is 63%, and the remaining 37% is ethyl styrene), 67 mol% of styrene, and toluene were added to a 1-liter jacketed reactor under nitrogen at 20°C. Boron trifluoride-diethyl ether complex catalyst was added to initiate the polymerization reaction. The color of the mixture slowly changed from colorless to brown. The mixture was stirred at 20°C for 1 hour, and then water was added to terminate the polymerization reaction to obtain a polymer stock solution.

### Purification Process

First, the polymer stock solution was filtered to remove impurities and water. The polymer stock solution was left at room temperature for 0 to 30 minutes. The yellow layer of the polymer stock solution was collected, and then concentrated using a rotary evaporator to obtain a 50 wt% varnish solution containing hydrocarbon resin polymer (Polymer 13). After analysis, in the varnish solution containing Polymer 13, based on 100 parts by weight of Polymer 13, the varnish solution further included 4.77 parts by weight of divinylbenzene, 3.5 parts by weight of ethyl styrene, 16 parts by weight of styrene, and 8.5 parts by weight of toluene.

### Varnish Solution Containing Polymer 14

### Reaction Process

20 mol% of dicyclopentadiene (DCPD), 13 mol% of divinylbenzene (The purity is 63%, and the remaining 37% is ethyl styrene), 67 mol% of styrene, and toluene were added to a 1-liter jacketed reactor under nitrogen at 20°C. Boron trifluoride-diethyl ether complex catalyst was added to initiate the polymerization reaction. The color of the mixture slowly changed from colorless to brown. The mixture was stirred at 20°C for 2 hours, and then water was added to terminate the polymerization reaction to obtain a polymer stock solution.

### Purification Process

First, the polymer stock solution was filtered to remove impurities and water. The polymer stock solution was left at room temperature for 0 to 30 minutes. The yellow layer of the polymer stock solution was collected, and then concentrated using a rotary evaporator to obtain a 50 wt% varnish solution containing hydrocarbon resin polymer (Polymer 14). After analysis, in the varnish solution containing Polymer 14, based on 100 parts by weight of Polymer 14, the varnish solution further included 1.9 parts by weight of divinylbenzene, 1.8 parts by weight of ethyl styrene, 12 parts by weight of styrene, and 28 parts by weight of toluene.

The material and proportion used to prepare Polymers 1 to 12 and the varnish solution containing Polymers 13 and 14 mentioned above are shown in the Table 1 below. The polymerization time, polymerization temperature, catalyst, and yield are shown in the Table 2 below.

**Table 1**

| | DCPD (mol %) | styrene (mol %) | methyl styrene (mol %) | ethyl styrene (mol %) | DVB (mol %) |
|---|---|---|---|---|---|
| Polymer 1 | 20 | 67 | 0 | 4.81 | 8.19 |
| Polymer 2 | 20 | 67 | 0 | 4.81 | 8.19 |
| Polymer 3 | 17 | 70 | 0 | 4.81 | 8.19 |
| Polymer 4 | 0 | 87 | 0 | 4.81 | 8.19 |
| Polymer 5 | 0 | 87 | 0 | 4.81 | 8.19 |
| Polymer 6 | 0 | 87 | 0 | 4.81 | 0.89 |
| Polymer 7 | 17 | 53 | 0 | 11.1 | 18.9 |
| Polymer 8 | 17 | 57 | 0 | 9.62 | 16.38 |
| Polymer 9 | 17 | 60 | 0 | 8.51 | 14.49 |
| Polymer 10 | 0 | 70 | 0 | 11.1 | 18.9 |
| Polymer 11 | 0 | 60 | 0 | 14.8 | 25.2 |
| Polymer 12 | 20 | 60 | 0 | 7.4 | 12.6 |
| Varnish Solution Containing Polymer 13 | 20 | 67 | 0 | 4.81 | 8.19 |
| Varnish Solution Containing Polymer 14 | 20 | 67 | 0 | 4.81 | 8.19 |

**Table 2**

| | polymerization time | polymerization temperature (°C) | catalyst | yield (%) |
|---|---|---|---|---|
| Polymer 1 | 3 hours | 0-15 | BF₃-OEt₂ | 44 |
| Polymer 2 | 2 hours | 15-20 | BF₃-OEt₂ | 52 |
| Polymer 3 | 2 hours | 10 | BF₃-OEt₂ | 45 |
| Polymer 4 | 1.5 hours | 20 | BF₃-OEt₂ | 50 |
| Polymer 5 | 4 hours | 20 | BF₃-OEt₂ | 50 |
| Polymer 6 | 0.5 hour | 25 | TiCl₄ | 81 |
| Polymer 7 | 2 hours | 0 | BF₃-OEt₂ | 30 |
| Polymer 8 | 2 hours | 0 | BF₃-OEt₂ | 35 |
| Polymer 9 | 2 hours | 0 | BF₃-OEt₂ | 40 |
| Polymer 10 | 3 hours | 40 | TiCl₄ | 53 |
| Polymer 11 | 1.5 hours | 75 | BF₃-OEt₂ | 57 |
| Polymer 12 | 3 hours | 20 | BF₃-OEt₂ | 38 |
| Varnish Solution Containing Polymer 13 | 1 hour | 20 | BF₃-OEt₂ | 44 |
| Varnish Solution Containing Polymer 14 | 2 hours | 20 | BF₃-OEt₂ | 44 |

The structural compositions of Polymers 1 to 14 were analyzed by nuclear magnetic resonance (NMR, JEOL, JNM-ECZ400S) through ¹³C-NMR and ¹H-NMR. It is understood that Polymers 1 to 14 included a repeating unit (A) derived from a bridged ring compound, a repeating unit (B) derived from a monovinyl aromatic compound, and a repeating unit (C) derived from a divinyl aromatic compound. Table 3 reveals the content of the repeating unit (A) derived from the bridged ring compounds, the content of the repeating units (B) derived from the monovinyl aromatic compound, the content of the repeating units (C) derived from the divinyl aromatic compound, and the sum of the content of the repeating unit (A) and the repeating unit (C).

**Table 3**

| | content of repeating unit (A) (mol%) | content of repeating unit (B) (mol%) | content of repeating unit (C) (mol%) | sum of content of repeating unit (A) and repeating unit (C) (mol%) |
|---|---|---|---|---|
| Polymer 1 | 4 | 77 | 19 | 23 |
| Polymer 2 | 6 | 75 | 19 | 25 |
| Polymer 3 | 4 | 79 | 17 | 21 |
| Polymer 4 | 0 | 89 | 11 | 11 |
| Polymer 5 | 0 | 91 | 9 | 9 |
| Polymer 6 | 0 | 87 | 12 | 12 |
| Polymer 7 | 2 | 68 | 30 | 32 |
| Polymer 8 | 2 | 73 | 25 | 27 |
| Polymer 9 | 2 | 74 | 23 | 25 |
| Polymer 10 | 0 | 76 | 23 | 23 |
| Polymer 11 | 0 | 70 | 30 | 30 |
| Polymer 12 | 2 | 70 | 25 | 27 |
| Polymer 13 | 3 | 70 | 27 | 30 |
| Polymer 14 | 6 | 76 | 19 | 25 |

### Measurements of Physical/Chemical Properties of Polymers 1 to 14

### [Measurement of Hydrogen Content on Reactive Double Bond]

Polymer 1 to Polymer 14 were dissolved in deuterated chloroform (CDCl₃), respectively. The hydrogen content on the reactive double bond of Polymers 1 to 14 was measured by NMR (JEOL, JNM-ECZ400S/L1), respectively. In particular, the hydrogen contents on the reactive double bond of Polymers 1 to 14 were calculated by dividing the sum of the integrated values of the hydrogens of the reactive double bond by the sum of the integrated values of all hydrogens.

### [Measurement of Number Average Molecular Weight (Mn) and Polymer Dispersity Index (PDI)]

Using polystyrene as a standard, the number average molecular weights (Mn) and polymer dispersion indexes (PDI) of Polymers 1 to 14 were measured through gel permeation chromatography (GPC) (Waters APC, column: Waters Acquity XT 900).

In particular, 5 mL of tetrahydrofuran (THF) was added to 0.01 g of Polymers 1 to 14, respectively, to prepare the samples of Polymers 1 to 14. The samples of Polymers 1 to 14 were filtered with a 0.22 µm filter and analyzed with instruments to obtain the number average molecular weights (Mn) and polymer dispersion indexes (PDI) of Polymers 1 to 14.

### [Measurement of Content of Cross-linkable Repeating Unit (C1)]

The structures of Polymers 1 to 14 were analyzed by NMR (JEOL, JNM-ECZ400S/L1) and GPC (Waters). CDCl₃ was used as the solvent and the resonance line of CDCl₃ was used as the internal standard to obtain the content of the cross-linkable repeating unit (C1) in Polymers 1 to 14.

The number average molecular weight (Mn), polymer dispersion index (PDI), hydrogen content on reactive double bond, and content of the cross-linkable repeating unit (C1) of Polymers 1 to 14 are shown in Table 4 below.

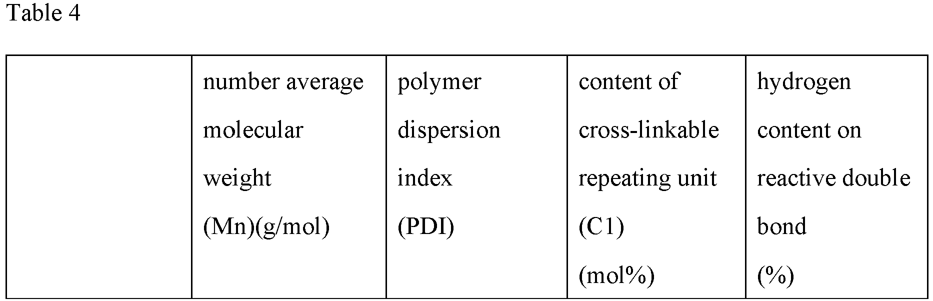

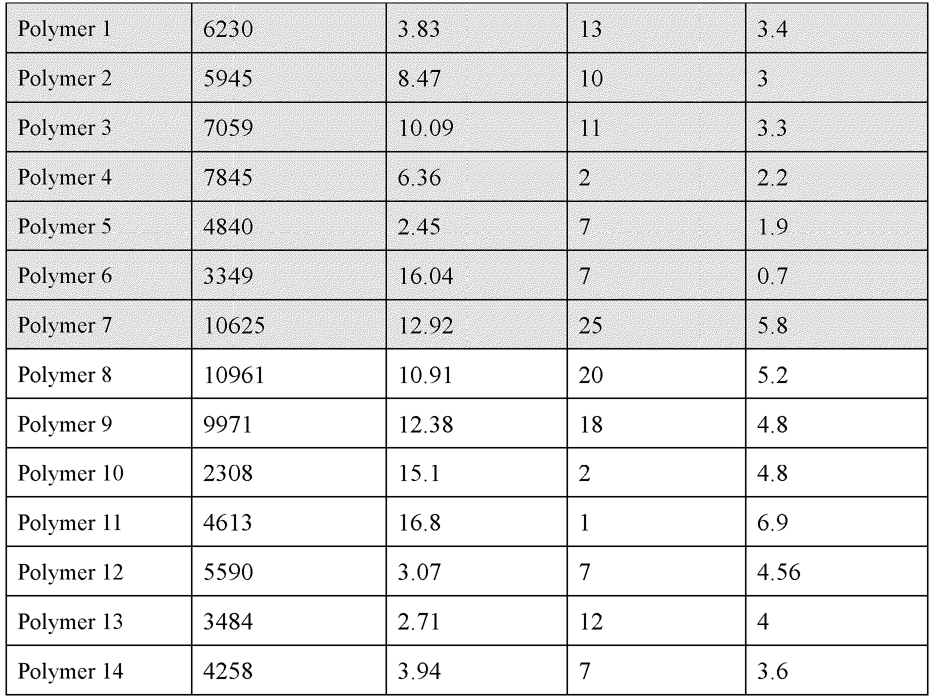

According to the proportions shown in Table 5-1 below, 100 parts by weight of Polymers 1 to 12 was respectively mixed with DVB, EVB, styrene, and toluene to form the varnish solution (corresponding to the resin compositions of the present disclosure) containing the Polymer. Then, additional ingredients were added to obtain the compositions of Examples 1 to 45. In addition, the contents of each ingredient in the varnish solution containing Polymer 13 and the varnish solution containing Polymer 14 (corresponding to the resin compositions of the present disclosure) are shown in Table 5-2 below. Additional ingredients were added according to the proportions shown in Table 5-2 to obtain the compositions of Examples 46 and 47. The content values of each ingredient shown in Tables 5-1 and 5-2 are expressed in parts by weight. For example, in Table 5-1, Example 1 includes 100 parts by weight of polymer 1, 100 parts by weight of toluene, 15 parts by weight of toughener, 0.3 parts by weight of peroxide, and 30 parts by weight of filler. The toughener in Tables 5-1 and 5-2 may be butadiene copolymers, such as Ricon 100 or Ricon 257; and the resin may be polyphenylene ether, such as SA9000. The filler may be SVC available from Admatch or SS-10 available from Tokuyama. The peroxide may be perbutyl P available from NOF Co., Ltd. In examples that include the filler, the filler was grounded using zirconium to a state of being uniformly dispersed in the compositions.

**Table 5-1**

| Exam ple | Varnish Solution Containing Polymers | | | | | Additional Ingredient | | | | |
|---|---|---|---|---|---|---|---|---|---|---|
| | Polymer (100 parts by weight) | DVB | EVB | Styrene | Toluene | Tough ener | Resin | TAIC | Pero xide | Fille r |
| 1 | Polymer 1 | 0 | 0 | 0 | 100 | 15 | 0 | 0 | 0.3 | 30 |
| 2 | Polymer 1 | 0.8 | 0.2 | 0 | 100 | 15 | 0 | 0 | 0.3 | 30 |
| 3 | Polymer 1 | 4 | 1 | 0 | 100 | 15 | 0 | 0 | 0.3 | 30 |
| 4 | Polymer 1 | 8 | 2 | 0 | 100 | 15 | 0 | 0 | 0.3 | 30 |
| 5 | Polymer 2 | 0 | 0 | 0 | 100 | 15 | 0 | 0 | 0.3 | 30 |
| 6 | Polymer 2 | 0.4 | 0.1 | 0 | 100 | 15 | 0 | 0 | 0.3 | 30 |
| 7 | Polymer 2 | 0.8 | 0.2 | 0 | 100 | 15 | 0 | 0 | 0.3 | 30 |
| 8 | Polymer 2 | 4 | 1 | 0 | 100 | 15 | 0 | 0 | 0.3 | 30 |
| 9 | Polymer 2 | 8 | 2 | 0 | 100 | 15 | 0 | 0 | 0.3 | 30 |
| 10 | Polymer 2 | 20 | 5 | 0 | 100 | 15 | 0 | 0 | 0.3 | 30 |
| 11 | Polymer 2 | 40 | 10 | 0 | 100 | 15 | 0 | 0 | 0.3 | 30 |
| 12 | Polymer 1 | 0 | 0 | 0 | 333.33 | 50 | 233.3 | 0 | 1.3 | 100 |
| 13 | Polymer 1 | 21 | 12.33 | 0 | 333.33 | 50 | 233.3 | 0 | 1.3 | 100 |
| 14 | Polymer 1 | 31.5 | 18.5 | 0 | 333.33 | 50 | 233.3 | 0 | 1.3 | 100 |
| 15 | Polymer 1 | 42 | 24.66 | 0 | 333.33 | 50 | 233.3 | 0 | 1.3 | 100 |
| 16 | Polymer 1 | 0 | 0 | 0 | 333.33 | 50 | 233.3 | 33.3 | 1.3 | 100 |
| 17 | Polymer 1 | 0 | 0 | 0 | 333.33 | 50 | 233.3 | 50 | 1.3 | 100 |
| 18 | Polymer 1 | 0 | 0 | 0 | 333.33 | 50 | 233.3 | 66.7 | 1.3 | 100 |
| 19 | Polymer 1 | 13.23 | 7.77 | 0 | 333.33 | 50 | 233.3 | 33.3 | 1.3 | 100 |
| 20 | Polymer 3 | 31.5 | 18.5 | 7.41 | 68.52 | 27.8 | 0 | 16.7 | 0.7 | 55.6 |
| 21 | Polymer 4 | 0 | 0 | 0 | 100 | 15 | 0 | 0 | 0.3 | 30 |
| 22 | Polymer 4 | 40 | 10 | 0 | 100 | 15 | 0 | 0 | 0.3 | 30 |
| 23 | Polymer 5 | 0 | 0 | 0 | 100 | 15 | 0 | 0 | 1 | 30 |
| 24 | Polymer 7 | 31.5 | 18.5 | 0 | 50 | 0 | 0 | 0 | 0 | 0 |
| 25 | Polymer 7 | 15.75 | 9.25 | 0 | 75 | 0 | 0 | 0 | 0 | 0 |
| 26 | Polymer 8 | 31.5 | 18.5 | 0 | 50 | 0 | 0 | 0 | 0 | 0 |
| 27 | Polymer 8 | 15.75 | 9.25 | 0 | 75 | 0 | 0 | 0 | 0 | 0 |
| 28 | Polymer 9 | 15.75 | 9.25 | 0 | 75 | 0 | 0 | 0 | 0 | 0 |
| 29 | Polymer 9 | 0 | 0 | 0 | 100 | 0 | 0 | 0 | 0 | 0 |
| 30 | Polymer 1 | 15.75 | 9.25 | 0 | 75 | 0 | 0 | 0 | 0 | 0 |
| 31 | Polymer 1 | 0 | 0 | 0 | 100 | 0 | 0 | 0 | 0 | 0 |
| 32 | Polymer 4 | 15.75 | 9.25 | 0 | 75 | 0 | 0 | 0 | 0 | 0 |
| 33 | Polymer 4 | 0 | 0 | 0 | 100 | 0 | 0 | 0 | 0 | 0 |
| 34 | Polymer 5 | 15.75 | 9.25 | 0 | 75 | 0 | 0 | 0 | 0 | 0 |
| 35 | Polymer 5 | 0 | 0 | 0 | 100 | 0 | 0 | 0 | 0 | 0 |
| 36 | Polymer 6 | 31.5 | 18.5 | 0 | 50 | 0 | 0 | 0 | 0 | 0 |
| 37 | Polymer 6 | 15.75 | 9.25 | 0 | 75 | 0 | 0 | 0 | 0 | 0 |
| 38 | Polymer 10 | 31.5 | 18.5 | 0 | 50 | 0 | 0 | 0 | 0 | 0 |
| 39 | Polymer 10 | 15.75 | 9.25 | 0 | 75 | 0 | 0 | 0 | 0 | 0 |
| 40 | Polymer 11 | 31.5 | 18.5 | 0 | 50 | 0 | 0 | 0 | 0 | 0 |
| 41 | Polymer 11 | 0 | 0 | 0 | 100 | 0 | 0 | 0 | 0 | 0 |
| 42 | Polymer 3 | 31.5 | 18.5 | 0 | 50 | 0 | 0 | 0 | 0 | 0 |
| 43 | Polymer 3 | 15.75 | 9.25 | 0 | 75 | 0 | 0 | 0 | 0 | 0 |
| 44 | Polymer 12 | 31.5 | 18.5 | 0 | 50 | 0 | 0 | 0 | 0 | 0 |
| 45 | Polymer 12 | 15.75 | 9.25 | 0 | 75 | 0 | 0 | 0 | 0 | 0 |

**Table 5-2**

| Exam ple | Varnish Solution Containing Polymers | | | | | Additional Ingredient | | | | |
|---|---|---|---|---|---|---|---|---|---|---|
| | Polymer (100 parts by weight) | DVB | EVB | Styrene | Toluene | Tough ener | Resi n | TAIC | Pero xide | Fille r |
| 46 | Polymer 13 | 4.77 | 3.5 | 16 | 8.5 | 15 | 0 | 9 | 1 | 30 |
| 47 | Polymer 14 | 1.9 | 1.8 | 12 | 28 | 15 | 0 | 9 | 1 | 30 |

Property Measurement of Substrate Samples of the Compositions of Examples 1 to 23, 46, and 47

A fiberglass cloth (Asahi 2116, Dk/Df=3.3/0.0030 at 28GHz) was dipped into the compositions of Examples 1 to 23, 46, and 47, respectively. The fiberglass cloth was then taken out and baked at 160°C for 7 minutes to obtain prepregs of Examples 1 to 23, 46, and 47. Two prepregs were stacked with two copper foil layers (RTF, Hoz (18µm), Rz: 3.5µm) so that the two prepregs were between the two copper foil layers. A silane adhesive (KBM503) was applied between the copper foil layers and the prepregs. At a temperature of 180°C to 210°C, a pressure of 441 psi was applied for 3 hours to obtain substrate samples of Examples 1 to 23, 46, and 47.

### [Measurement of Glass Transition Temperature (Tg)]

The substrate samples of Examples 1 to 23, 46, and 47 were heated from 25°C to 270°C at a rate of 3°C/min. The glass transition temperatures (Tg) of the substrate samples of Examples 1 to 23, 46, and 47 were measured using dynamic mechanical analysis (DMA, TA/Q800). The test frequency is 1 Hz. The glass transition temperatures (Tg) of the substrate samples of Examples 1 to 23, 46, and 47 were obtained from the tan Delta peak in the DMA chart.

### [Thermal Decomposition Temperature (Td)]

The thermal decomposition temperatures (Td) of the substrate samples of Examples 1 to 23, 46, and 47 were measured using thermogravimetric analysis (TGA, TA/Q500). The range of test temperature was room temperature to 900°C. Heating rate was 10°C/min without protection of nitrogen flow.

### [Measurement of Resin Flow]

After the substrate sample was formed, a length measuring tool (such as a ruler) was used to measure the edge of the resin layer of the substrate sample to determine the length of the resin flow. In particular, the substrate sample included the copper foil layer and the resin layer containing the compositions of Examples 1 to 23, 46, and 47. The compositions of Examples 1 to 23, 46, and 47 would partially overflow (i.e., beyond the fiberglass cloth) during the thermoforming stage. The lengths of the resin flow were the average lengths of the compositions of Examples 1 to 23, 46, and 47 measured beyond the edge of the fiberglass cloth.

### [Measurement of Percent of Thermal Expansion (PTE)]

A thermomechanical analyzer (Thermomechanical Analysis, model: Q400, brand: TA) was used according to the following steps.

Cycle 1 to Cycle 4 were executed in sequence, and Cycle 3 was set as the measurement benchmark. The dimensions were taken at different temperatures (50°C and 260°C) to calculate the percentage change in size. Cycle 1: under N₂ environment, achieve balance at 25°C, hold constant temperature for 1 minute, and heat from 25°C to 270°C at a rate of 20°C/min. Cycle 2: cool from 270°C to 25°C at a rate of 20°C/min, hold constant temperature for 1 minute, and achieve balance at 25°C. Cycle 3: heat from 25°C to 270°C at a rate of 10°C /min. Cycle 4: cool from 270°C to 25°C at a rate of 20°C/min.

### [Test of Electrical Performance]

The Dk/Df of the substrate samples of Examples 1 to 23, 46, and 47 were measured through network analyzer Keysight, P5007A, SCR at 10GHz, 28GHz, and 40GHz.

### [Test of Peeling Strength]

A fiberglass cloth (Asahi 2116, Dk/Df=3.3/0.0030 at 28GHz) was dipped into the compositions of Examples 1 to 23, 46, and 47, respectively. The fiberglass cloth was then taken out and baked at 160°C for 7 minutes to obtain prepregs of Examples 1 to 23, 46, and 47. A silane adhesive (KBM503) was applied on the surfaces of two copper foil layers. Four prepregs were stacked with the two copper foil layers (RTF, Hoz (18µm), Rz: 3.5µm) so that the four prepregs were between the two copper foil layers. The silane adhesive (KBM503) was applied between the copper foil layers and the prepregs. At a temperature of 180°C to 210°C, a pressure of 441 psi was applied for 3 hours to obtain substrate samples of Examples 1 to 23, 46, and 47. Next, SHIMADZU AG-Xplus was used to measure the peel strengths of the substrate samples of Examples 1 to 23, 46, and 47 with size of 12.7 mm × 20 mm at a peeling rate of 50.8 mm/min.

The resin flow, peel strength, glass transition temperature, PTE, and Td of the substrate samples of Examples 1 to 23, 46, and 47 are shown in Table 6 below. The dielectric constant/loss tangent (Dk/Df) of the substrate samples of Examples 1 to 23, 46, and 47 at 10 GHz, 28 GHz, and 40 GHz are shown in Table 7 below.

**Table 6**

| Exampl e | resin flow (cm) | peel strength (lbf/inch) | glass transition temperature (Tg, °C) | PTE (%) | thermal decomposition temperature (Td, °C) |
|---|---|---|---|---|---|
| 1 | 1.1 | 2.58 | 153 | 3.35 | 391 |
| 2 | 1 | 2.63 | 157 | 2.46 | 394 |
| 3 | 0.8 | 2.63 | 158 | 4.14 | 394 |
| 4 | 0.6 | 2.58 | 158 | 4.68 | 393 |
| 5 | 1.7 | 2.38 | 144 | 3.14 | 400 |
| 6 | 2.1 | 2.45 | 144 | 3.75 | 404 |
| 7 | 1.3 | 2.54 | 145 | 2.38 | 397 |
| 8 | 0.7 | 2.31 | 146 | 3.12 | 394 |
| 9 | 1.4 | 2.4 | 148 | 3.56 | 403 |
| 10 | 0.5 | 2.49 | 153 | 3.93 | 405 |
| 11 | 0.4 | 2.27 | 152 | 3.95 | 407 |
| 12 | 0.4 | 2.07 | 159 | 3.83 | 422 |
| 13 | 0.5 | 3.66 | 197 | 3.96 | 409 |
| 14 | 0.4 | 3.64 | 199 | 3.66 | 412 |
| 15 | 0.2 | 3.48 | 200 | 3.67 | 409 |
| 16 | 1 | 3.6 | 198 | 2.97 | 413 |
| 17 | 1.5 | 3.65 | 203 | 3.33 | 416 |
| 18 | 1.9 | 3.62 | 198 | 3.06 | 418 |
| 19 | 0.9 | 3.47 | 201 | 3.3 | 438 |
| 20 | 0.6 | 1.96 | 151 | 4.1 | 392 |
| 21 | 2.6 | 2.41 | 144 | 4.4 | 383 |
| 22 | 1.5 | 2.35 | 144 | 5 | 396 |
| 23 | 3.4 | 2.01 | unmeasured | unmeasured | unmeasured |
| 46 | 0.2 | 2.13 | 145 | 2 | 402 |
| 47 | 1.8 | 2.58 | 142 | 5 | 397 |

**Table 7**

| Example | Dk/Df@10 GHz | Dk/Df@28 GHz | Dk/Df @40 GHz | fuming |
|---|---|---|---|---|
| 1 | 2.94/0.0018 | 3.04/0.0023 | unmeasured | X |
| 2 | 3.00/0.0018 | 3.04/0.0024 | unmeasured | X |
| 3 | 3.02/0.0018 | 3.03/0.0023 | unmeasured | X |
| 4 | 3.18/0.0019 | 3.27/0.0025 | unmeasured | X |
| 5 | 3.19/0.0017 | 3.73/0.0023 | unmeasured | X |
| 6 | 3.33/0.0017 | 3.19/0.0022 | unmeasured | X |
| 7 | 3.00/0.0017 | 2.74/0.0021 | unmeasured | X |
| 8 | 2.50/0.0016 | 2.50/0.0021 | unmeasured | X |
| 9 | 2.57/0.0017 | 2.68/0.0021 | unmeasured | X |
| 10 | 3.17/0.0018 | 3.11/0.0024 | unmeasured | X |
| 11 | 3.34/0.0020 | 3.39/0.0026 | unmeasured | X |
| 12 | 3.04/0.0020 | 3.11/0.0026 | 3.06/0.0027 | X |
| 13 | 3.12/0.0025 | 3.14/0.0031 | 3.15/0.0033 | X |
| 14 | 3.07/0.0025 | 3.17/0.0032 | 3.20/0.0034 | X |
| 15 | 3.19/0.0025 | 3.18/0.0031 | 3.21/0.0033 | X |
| 16 | 2.97/0.0026 | 3.00/0.0032 | 2.99/0.0035 | O |
| 17 | 3.06/0.0026 | 3.15/0.0032 | 3.11/0.0035 | O |
| 18 | 3.75/0.0028 | 3.72/0.0036 | 3.02/0.0034 | O |
| 19 | 3.01/0.0025 | 3.10/0.0032 | 3.02/0.0034 | O |
| 20 | 3.28/0.0025 | 3.19/0.0031 | unmeasured | O |
| 21 | 3.19/0.0021 | 3.22/0.0028 | unmeasured | unmeasured |
| 22 | 3.11/0.0019 | 3.07/0.0025 | unmeasured | unmeasured |
| 23 | 3.26/0.0020 | 3.20/0.0026 | unmeasured | unmeasured |
| 46 | 3.26/0.0023 | 3.41/0.0030 | unmeasured | unmeasured |
| 47 | 3.024/0.0019 | 3.020/0.0024 | unmeasured | unmeasured |

| | | | | |
|---|---|---|---|---|
| Fuming is observed with eyes (O: Yes. X: No.) | | | | |

### [Measurement of Rheological Property]

A pipette was used to draw 0.55 mL of the compositions of Examples 24 to 45 on a rheometer (model: MCR302, brand: Anton Paar). Temperature scans were performed with the following parameters to measure changes in rheological properties of the compositions of Examples 24 to 45 in the temperature range of 40°C to 210°C: pre-equilibration: shear rate = 1 (1/s) for 60 seconds; holding time: 60 seconds (40°C); experimental temperature: 40 to 210°C; strain: 0.1%; and frequency: 10 rad/s.

The measured rheological properties include loss modulus and storage modulus. Loss modulus is often related to fluid properties. Therefore, it can be said that the loss modulus reflects the liquid-state behavior of the material. Storage modulus is often related to solid properties. Therefore, it can be said that the storage modulus reflects the solid-state behavior of the material. When the temperature increases, the changes in loss modulus and storage modulus can be used to understand the process of the resin composition transitioning from liquid to solid state.

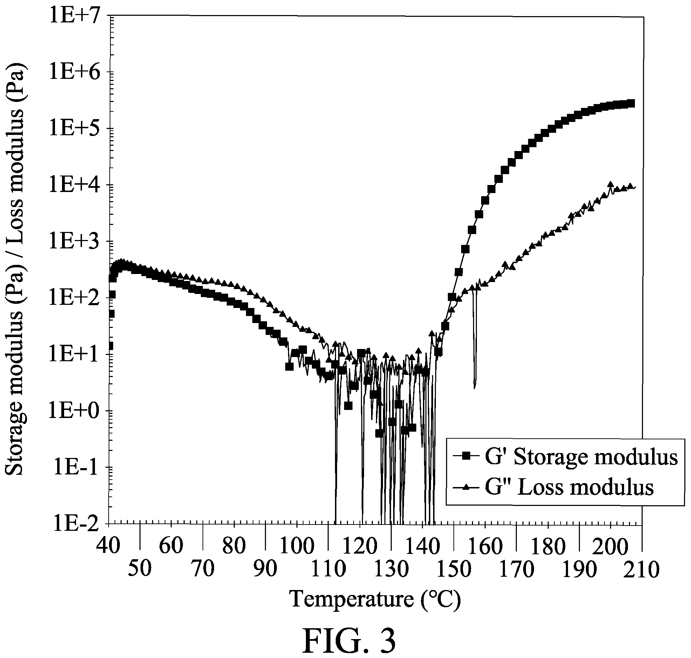

Figure 3 is a graph illustrating the relationship between storage modulus and loss modulus of the composition of Example 30 and temperature. It can be seen from Figure 3 that the loss modulus may be higher at low temperature, indicating that the composition of Example 30 exhibits more liquid-state properties at low temperature. At 146.89°C, the storage modulus begins to exceed the loss modulus, indicating a gradual transition of the composition of Example 30 to a solid state because the composition of Example 30 begin to cross-link or cure. At higher temperatures, the storage modulus of the composition of Example 30 is significantly higher than the loss modulus, indicating that the material behaves primarily in the solid state. The temperature at which the storage modulus of each composition begins to exceed the loss modulus is defined herein as the cross-linkable temperature. That is, according to Figure 3, the cross-linkable temperature of the composition of Example 30 is approximately 146.89°C.

### [Measurement of Storage Modulus at 2,000 Seconds]

A pipette was used to draw 0.55 mL of the compositions of Examples 24 to 45 on the rheometer (model: MCR302, brand: Anton Paar). Time scans were performed with the following parameters: pre-equilibration: shear rate = 1 (1/s) for 60 seconds; experimental temperature: 160°C; strain: 0.1%; and frequency: 10 rad/s. The storage modulus of the compositions of Examples 24 to 45 were measured at 2,000 seconds.

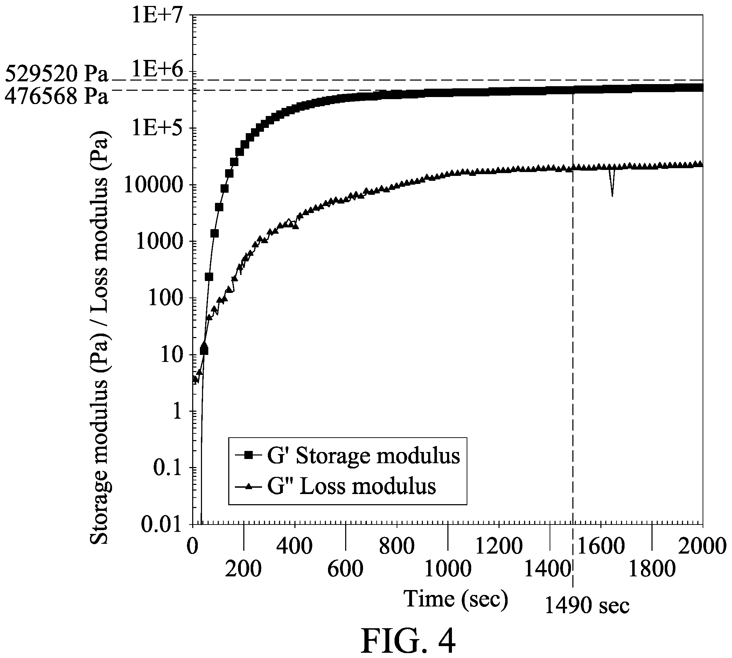

Figure 4 is a graph illustrating the relationship between storage modulus and loss modulus of the composition of Example 30 and time. Referring to Figure 4, it can be seen that at a cross-linking temperature of 160°C, the storage modulus of the composition of Example 30 increases with increasing cross-linking time. The increase in storage modulus levels off after 2,000 seconds of cross-linking time. Referring to Figure 4, it can be seen that the composition of Example 30 has a storage modulus of 529,520 Pa after the cross-linking time of 2,000 seconds at the cross-linking temperature of 160°C.

### [Measurement of Required Cross-linking Time]

Same as above, during the time scans, the cross-linking time corresponding to the storage modulus obtained by multiplying the storage modulus of the compositions of Examples 24 to 45 after a cross-linking time of 2,000 seconds by 0.9 times is defined as the "required cross-linking time." In particular, referring to Figure 4, it can be seen that the composition of Example 30 has a storage modulus of 529,520 Pa after the cross-linking time of 2,000 seconds at the cross-linking temperature of 160°C. The "required cross-linking time" is 1,490 seconds (the cross-linking time corresponding to obtain the storage modulus of 476,568 Pa (0.9 × 529,520)).

### [Measurement of Complex Viscosity of Composition at 1/2 Required Cross-linking Time]

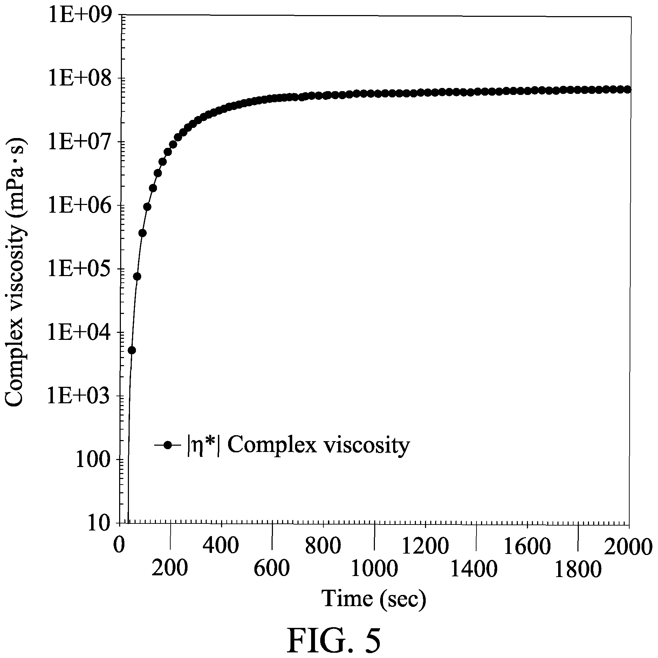

Same as above, during the time scans, the complex viscosities of the compositions of Examples 24 to 45 were measured after half of the "required cross-linking time" and recorded as "complex viscosity at 1/2 required cross-linking time." Figure 5 is a graph illustrating the relationship between the complex viscosity of the composition of Example 30 and time. Referring to Figure 5, it can be seen that after half of the "required cross-linking time" (i.e. 1,490 seconds/2=745 seconds) at the cross-linking temperature of 160°C, the complex viscosity of the composition of Example 30 is 3.82 × 10⁷ cP.

The measured cross-linkable temperature, required cross-linking time, complex viscosity at 1/2 required cross-linking time, and storage modulus at 2,000 seconds of the compositions of Examples 24 to 45 are shown in Table 8 below.

**Table 8**

| Example | cross-linkable temperature (°C) | required cross-linking time (s) | complex viscosity at 1/2 required cross-linking time (cP) | storage modulus @2,000 s (Pa) |
|---|---|---|---|---|
| 24 | 142.68 | 1715 | 5.31 × 10⁷ | 1,075,100 |
| 25 | 143.21 | 1760 | 2.47 × 10⁷ | 491,540 |
| 26 | 144.62 | 1780 | 5.68 × 10⁷ | 1,210,500 |
| 27 | 145.64 | 1790 | 1.80 × 10⁷ | 389,170 |
| 28 | 137.16 | 1315 | 5.3 × 10⁷ | 796,620 |
| 29 | 144.72 | 1720 | 1.29 × 10⁷ | 218,690 |
| 30 | 146.89 | 1490 | 3.82 × 10⁷ | 529,520 |
| 31 | 147.49 | 1680 | 1.26 × 10⁷ | 216,870 |
| 32 | 158 | 1695 | 8.72 × 10⁶ | 147,980 |
| 33 | 172 | 1735 | 1.12 × 10⁵ | 1,818 |
| 34 | 144.83 | 1570 | 1.61 × 10⁶ | 25,139 |
| 35 | 152 | 1745 | 1.6 × 10⁴ | 32,705 |
| 36 | 142.18 | 1705 | 1.68 × 10⁷ | 321,830 |
| 37 | 147.83 | 1670 | 1.56 × 10⁶ | 24,429 |
| 38 | 135.23 | 1420 | 4.67 × 10⁷ | 724,840 |
| 39 | 140.21 | 1710 | 2.72 × 10⁷ | 426,970 |
| 40 | 135.23 | 1420 | 4.67 × 10⁷ | 724,840 |
| 41 | 136.97 | 1755 | 1.49 × 10⁷ | 240,080 |
| 42 | 156 | 1800 | 2.43 × 10⁷ | 517,570 |
| 43 | 163 | 1820 | 4.92 × 10⁶ | 124,370 |
| 44 | 143.59 | 1300 | 1.86 × 10⁸ | 2,908,000 |
| 45 | 144.71 | 1355 | 2.25 × 10⁷ | 449,150 |

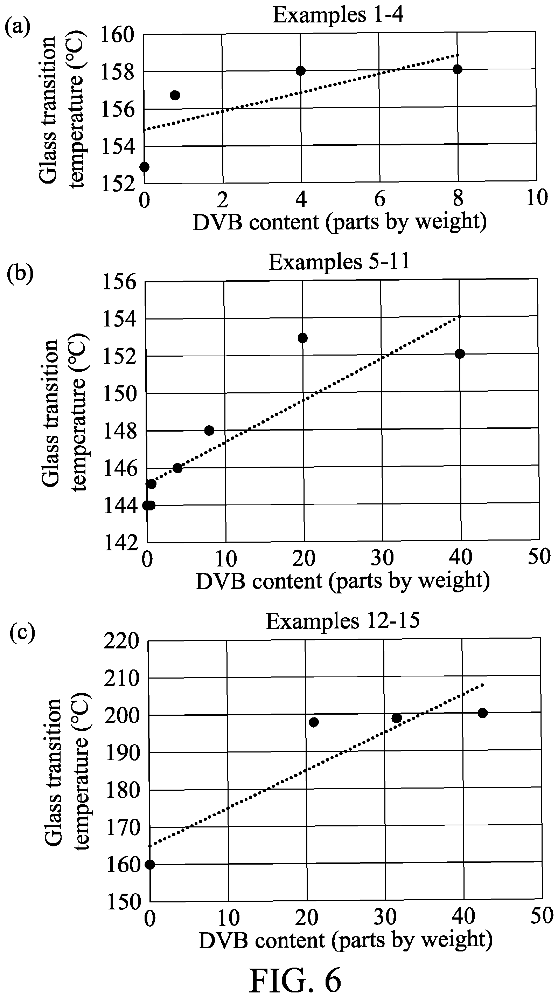

Figure 6 is a graph illustrating the relationship between the glass transition temperature of the resin composition and the DVB content in the resin composition according to the present disclosure. Figure 6(a) is a graph illustrating the relationship between the glass transition temperature of the substrate samples of Examples 1 to 4 and the DVB content in the compositions of Examples 1 to 4. Figure 6(b) is a graph illustrating the relationship between the glass transition temperature of the substrate samples of Examples 5 to 11 and the DVB content in the compositions of Examples 5 to 11. Figure 6(c) is a graph illustrating the relationship between the glass transition temperature of the substrate samples of Examples 12 to 15 and the DVB content in the compositions of Examples 12 to 15. According to Figure 6, it can be seen that the more DVB content in the resin composition, the higher the glass transition temperature. In particular, it can be seen from Figure 6(a) that, compared to the substrate sample of Example 1 (without DVB), the substrate samples of Examples 2 to 4 have higher glass transition temperatures. It can be seen from Figure 6(b) that, compared to the substrate sample of Example 5 (without DVB), the substrate samples of Examples 7 to 11 have higher glass transition temperatures, and the glass transition temperatures are proportional to the DVB contents in the compositions. It can be seen from Figure 6(c) that, compared to the substrate sample of Example 12 (without DVB), the substrate samples of Examples 13 to 15 have higher glass transition temperatures, and the glass transition temperatures are proportional to the DVB contents in the compositions.

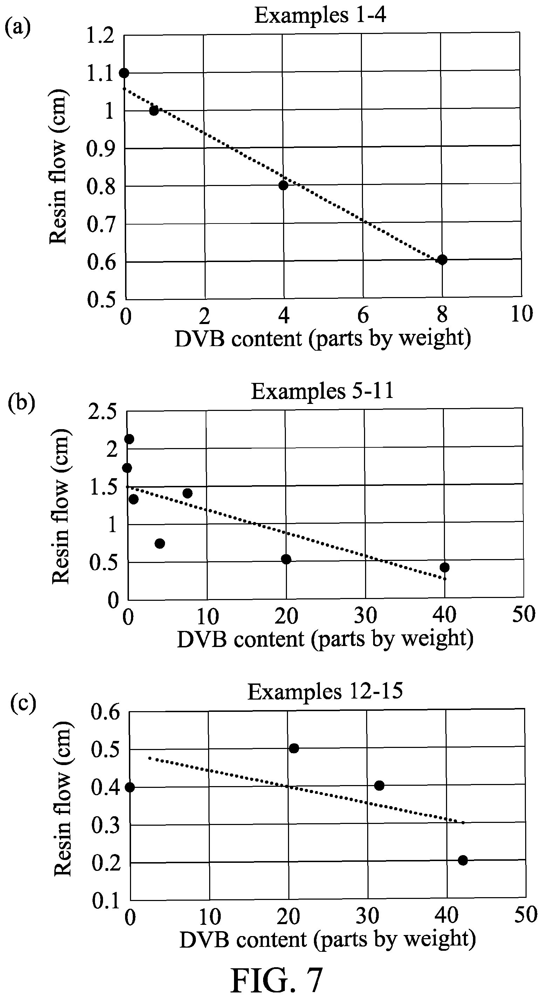

Figure 7 is a graph illustrating the relationship between the resin flow of the resin composition and the DVB content in the resin composition according to the present disclosure. Figure 7(a) is a graph illustrating the relationship between the resin flow of the substrate samples of Examples 1 to 4 and the DVB content in the compositions of Examples 1 to 4. Figure 7(b) is a graph illustrating the relationship between the resin flow of the substrate samples of Examples 5 to 11 and the DVB content in the compositions of Examples 5 to 11. Figure 7(c) is a graph illustrating the relationship between the resin flow of the substrate samples of Examples 12 to 15 and the DVB content in the compositions of Examples 12 to 15. It can be seen from Figure 7(a) that, compared to the substrate sample of Example 1 (without DVB), the resin flows of the substrate samples of Examples 2 to 4 are improved, and the lengths of resin flows are inversely proportional to the DVB contents in the compositions. It can be seen from Figure 7(b) that, compared to the substrate sample of Example 5 (without DVB), the resin flows of the substrate samples of Examples 7 to 11 are improved, and the lengths of resin flows are inversely proportional to the DVB contents in the compositions. It can be seen from Figure 7(c) that, compared to the substrate sample of Example 12 (without DVB), the resin flow of the substrate sample of Example 15 is improved.

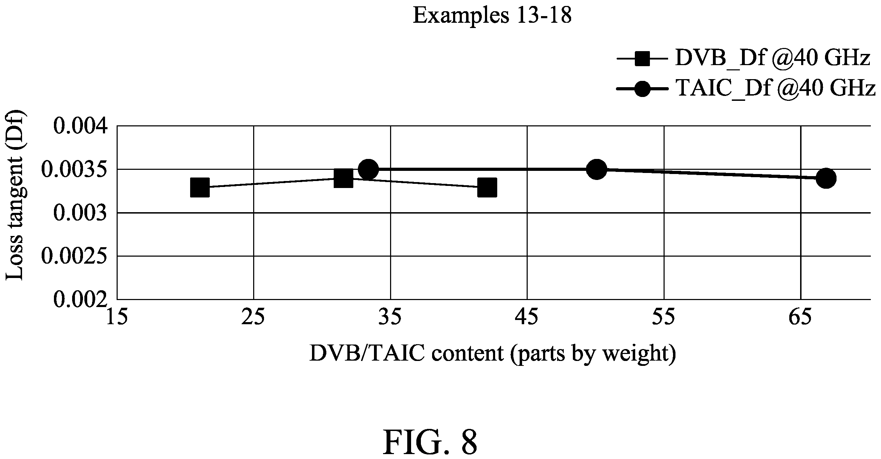

According to Table 7, it can be seen that the compositions of the present disclosure have excellent electrical performance. In particular, compared to the substrate samples of Examples 16 to 18 (including TAIC but excluding DVB), the loss tangent (Df) of the substrate samples of Examples 13 to 15 (including DVB but excluding TAIC) at 10GHz, 28GHz, and 40GHz are reduced (that is, improved). Figure 8 is a graph illustrating the relationship between the loss tangent (Df) of the substrate samples of Examples 13 to 18 and the DVB/TAIC content in the resin compositions. As can be seen from Figure 8, DVB with the same content has better electrical performance (lower Df) than TAIC. In other words, according to Table 7 and Figure 8, When the compositions of the present disclosure are subsequently used to make prepregs and copper foil substrates, substrate samples with excellent electrical properties can be completed without using the conventional cross-linking agent, such as triallyl isocyanurate (TAIC).

Further, since there is no need to use the TAIC cross-linking agent when using the compositions of the present disclosure to make prepregs and copper foil substrates, there is no fuming. Furthermore, compared to the TAIC cross-linking agent, DVB in the compositions can also increase the solubility of the hydrocarbon resin polymers, resulting in better processability.

According to Table 8, when including the same polymer, compared to Examples 29, 31, 33, 35, and 41 that do not include DVB, Examples 28, 30, 32, 34, and 40 that include more than 0.01 parts by weight of DVB have lower cross-linkable temperatures and/or have lower required cross-linking times. Accordingly, when the same polymer is included, 0.01 to 50 parts by weight of DVB can carry out the cross-linking reaction in a shorter time and/or lower temperature, reducing the energy consumption required for the cross-linking reaction.

100 parts by weight of Polymer 1 and 100 parts by weight of toluene were mixed to form a Composition A. 10 parts by weight of DVB, 100 parts by weight of Polymer 1, and 100 parts by weight of toluene were mixed to form a Composition B. 20 parts by weight of DVB, 100 parts by weight of Polymer 1, and 100 parts by weight of toluene were mixed to form a Composition C. The viscosities of Compositions A to C at 25°C were measured through a TOKI SANGYO electromagnetic force balance viscometer. The measured viscosities are shown in Table 9 below. The content values of each component in Table 9 are expressed in parts by weight.

**Table 9**

| | Composition A | Composition B | Composition C |
|---|---|---|---|
| DVB(parts by weight) | 0 | 10 | 20 |
| Polymer 1(parts by weight) | 100 | 100 | 100 |
| toluene (parts by weight) | 100 | 100 | 100 |
| viscosity (cp) | 271.1 | 203.8 | 143.9 |

It can be seen from Table 9 that DVB in the composition can reduce the viscosity of the resin composition, thereby having better processability. In particular, compared to Composition A (without DVB), the viscosities of Compositions B and C (with DVB) are significantly reduced.

According to the above various embodiments and test results, when preparing the resin composition of the present disclosure, some embodiments do not require the use of organic solvent for purification, which is environmentally friendly and the cost is reduced. Since the resin composition of the present disclosure has low composition viscosity, low cross-linking temperature, and short required cross-linking time, it can have the advantages of low energy consumption, low cost, and/or environmental friendliness when using the resin composition of the present disclosure to manufacture the substrate structure. In addition, using the resin composition of the present disclosure to manufacture the substrate structure does not result in fuming, and the resin flow is improved. The substrate structure manufactured from the resin composition of the present disclosure also has good thermal property (high glass transition temperature (Tg)) and/or electrical performance.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A resin composition, comprising:
100 parts by weight of a hydrocarbon resin polymer; and
0.01 to 50 parts by weight of a divinyl aromatic compound.

2. The resin composition as claimed in claim 1, wherein based on 100 mol% of the hydrocarbon resin polymer, the hydrocarbon resin polymer comprises:
15 to 95 mol% of a repeating unit (B), which is derived from a monovinyl aromatic compound; and
5 to 85 mol% of a repeating unit (C), which is derived from a divinyl aromatic compound.

3. The resin composition as claimed in claim 2, wherein based on 100 mol% of the hydrocarbon resin polymer, the hydrocarbon resin polymer further comprises 0.15 to 15 mol% of a repeating unit (A), which is derived from a bridged ring compound.

4. The resin composition as claimed in claim 3, wherein based on 100 mol% of the hydrocarbon resin polymer, a sum of the repeating unit (A) and the repeating unit (C) of the hydrocarbon resin is greater than or equal to 13 mol%.

5. The resin composition as claimed in claim 3, wherein a hydrogen atom content in reactive double bonds of the hydrocarbon resin polymer is less than 10%.

6. The resin composition as claimed in claim 2, wherein the repeating unit (C) comprises a cross-linkable repeating unit (C1) and a cross-linked repeating unit (C2): 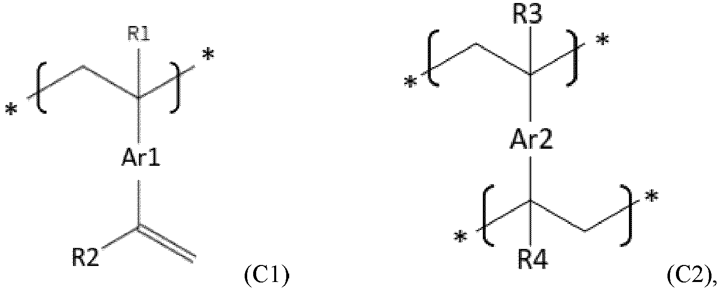
wherein R1, R2, R3, and R4 are each independently H or C₁₋₂₀ alkyl, and Ar1 and Ar2 are phenylene groups;
*indicates a position where the cross-linkable repeating unit (C1) and the cross-linked repeating unit (C2) is connected to other groups or units; and
based on 100 mol% of the hydrocarbon resin polymer, a content of the cross-linkable repeating unit (C1) is 1 to 30 mol%.

7. The resin composition as claimed in claim 1, wherein the resin composition has a cross-linkable temperature of 125°C to 165°C.

8. The resin composition as claimed in claim 1, wherein the resin composition has a storage modulus of 10,000 to 10,000,000 Pa after cross-linking at a cross-linking temperature of 160°C and a cross-linking time of 2,000 seconds.

9. The resin composition as claimed in claim 8, wherein a required cross-linking time for the resin composition to reach 0.9 times the storage modulus is 1300 to 1900 seconds.

10. The resin composition as claimed in claim 9, wherein the resin composition has a complex viscosity of 1.00 × 10⁴ to 6.00 × 10⁸ cP after half of the required cross-linking time at a cross-linking temperature of 160°C.

11. A manufacturing method of a resin composition, comprising the following steps:
providing a mixture, wherein the mixture comprises a monovinyl aromatic compound and a divinyl aromatic compound, and optionally comprises a bridged ring compound;
polymerizing the mixture to form a crude composition; and
purifying the crude composition to prepare a resin composition,
wherein the resin composition comprises:
100 parts by weight of a hydrocarbon resin polymer; and
0.01 to 50 parts by weight of a divinyl aromatic compound.

12. The manufacturing method of a resin composition as claimed in claim 11, wherein the step of purifying the crude composition comprises extracting the crude composition with water.

13. The manufacturing method of a resin composition as claimed in claim 11, wherein the manufacturing method of the resin composition further comprises a step of adding a divinyl aromatic compound after the step of purifying the crude composition, wherein the step of purifying the crude composition comprises extracting the crude composition with isopropyl alcohol (IPA).

14. A substrate structure, comprising:
a resin layer (201), and
a conductive layer (203) disposed on the resin layer (201);
wherein the resin layer (201) is formed from a resin composition using a cross-linking process, and the resin composition comprises:
100 parts by weight of a hydrocarbon resin polymer; and
0.01 to 50 parts by weight of a divinyl aromatic compound.

15. The substrate structure as claimed in claim 14, wherein the cross-linking process does not use a triallyl isocyanurate (TAIC) cross-linking agent.
